(19) Europäisches Patentamt
European Patent Office
Office européen des brevets

(11) **EP 1 225 481 B1**

(12) **EUROPÄISCHE PATENTSCHRIFT**

(45) Veröffentlichungstag und Bekanntmachung des Hinweises auf die Patenterteilung:
**15.08.2007 Patentblatt 2007/33**

(51) Int Cl.:
*G03F 7/20* (2006.01)     *G21K 1/06* (2006.01)
*G21K 5/04* (2006.01)

(21) Anmeldenummer: **01128685.3**

(22) Anmeldetag: **01.12.2001**

(54) **Kollektor für Beleuchtungssysteme**

Collector for an illumination system

Collecteur pour un système d'illumination

(84) Benannte Vertragsstaaten:
**DE FR GB IT NL**

(30) Priorität: **23.01.2001 DE 10102934**
**06.06.2001 DE 10127298**
**10.08.2001 DE 10138313**

(43) Veröffentlichungstag der Anmeldung:
**24.07.2002 Patentblatt 2002/30**

(73) Patentinhaber: **Carl Zeiss SMT AG**
**73447 Oberkochen (DE)**

(72) Erfinder:
• **Singer, Wolfgang, Dr.**
**73431 Aalen (DE)**

• **Wangler, Johannes**
**85551 Königsbronn (DE)**
• **Antoni, Martin**
**73434 Aalen (DE)**

(74) Vertreter: **Sawodny, Michael-Wolfgang**
**Adolf - Lüken - Höflich - Sawodny,**
**Dreiköniggasse 10**
**89073 Ulm (DE)**

(56) Entgegenhaltungen:
**EP-A- 0 627 667      DE-A1- 19 903 807**
**US-A- 4 525 853      US-A- 6 064 072**

**Beschreibung**

Die Erfindung betrifft einen Kollektor für Beleuchtungssysteme mit einer Wellenlänge ≤ 193 nm, bevorzugt ≤ 126 nm, insbesondere bevorzugt Wellenlängen im EUV-Bereich mit einer objektseitigen Apertur entsprechend dem Anspruch 1. Des weiteren stellt die Erfindung auch ein Beleuchtungssystem mit einem derartigen Kollektor entsprechend dem Anspruch 12, einer Projektionsbelichtungsanlage mit einem erfindungsgemäßen Beleuchtungssystem entsprechend dem Anspruch 24 sowie ein Verfahren zur Belichtung von Mikrostrukturen entsprechend dem Anspruch 25 zur Verfügung.

Genestete Kollektoren für Wellenlängen ≤ 193 nm, insbesondere Wellenlängen im Bereich der Röntgenstrahlen sind aus einer Vielzahl von Schriften bekanntgeworden.

So zeigt die US 5,768,339 einen Kollimator für Röntgenstrahlen, wobei der Kollimator mehrere genestete paraboloidförmige Reflektoren aufweist. Der Kollimator gemäß der US 5,768,339 dient dazu, ein isotrop abgestrahltes Strahlbündel einer Röntgen-Lichtquelle in einen parallelen Strahl zu formen.

Aus der US-A-1865441 ist ein genesteter Kollektor für Röntgenstrahlen bekanntgeworden, der wie im Falle der US 5,768,339 dazu dient, von einer Quelle abgegebene isotrope Röntgenstrahlen zu einem parallelen Strahlbündel zu kollimieren.

Die US 5,763,930 zeigt einen genesteten Kollektor für eine Pinch-Plasma-Lichtquelle, der dazu dient, die von der Lichtquelle abgegebene Strahlung zu sammeln und in einen Lichtleiter zu bündeln.

Die US 5,745,547 zeigt mehrere Anordnungen von Multikanaloptiken, die dazu dienen, durch Mehrfachreflexionen die Strahlung einer Quelle, insbesondere Röntgenstrahlung, in einem Punkt zu bündeln.

Um eine besonders hohe Transmissionseffizienz zu erreichen, schlägt die Erfindung gemäß der US 5,745,547 elliptisch geformte Reflektoren vor.

Aus der DE 30 01 059 C2 ist für die Verwendung in Röntgenstrahlen-Lithographiesystemen eine Anordnung bekanntgeworden, die parabolische zwischen Röntgenstrahlquelle und Maske angeordnete genestete Spiegel aufweist. Diese Spiegel sind so angeordnet, daß die divergierenden Röntgenstrahlen zu einem parallel verlaufenden Ausgangsstrahlbüschel geformt werden.

Die Anordnung gemäß der DE 30 01 059 dient wiederum lediglich dazu, für die Röntgenstrahl-Lithographie eine gute Kollimation zu erreichen.

Die aus der WO 99/27542 bekanntgewordene Anordnung von genesteten Reflektoren dient bei einem Röntgenstrahl-Proximity-Lithographie-System dazu, daß Licht einer Lichtquelle zu refokussieren, so daß eine virtuelle Lichtquelle ausgebildet wird. Die genesteten Schalen können Ellipsoidform aufweisen.

Aus der US 6,064,072 ist ein genesteter Reflektor für hochenergetische Photonenquellen bekanntgeworden, der dazu dient, die divergierenden Röntgenstrahlen zu einem parallel verlaufenden Strahlbüschel zu formen.

Die US 6,064,072 wird als nächstliegender Stand der Technik angesehen.

Die WO 00/63922 zeigt einen genesteten Kollektor, der dazu dient, den Neutronenstrahl zu kollimieren.

Aus der WO 01/08162 ist ein genesteter Kollektor für Röntgenstrahlen bekanntgeworden, der sich durch eine Oberflächenrauigkeit der inneren, reflektierenden Fläche, der einzelnen Spiegelschalen von weniger als 12 Å rms auszeichnet. Die in der WO 01/08162 gezeigten Kollektoren umfassen auch Systeme mit Mehrfachreflexionen, insbesondere auch Woltersysteme, und zeichnen sich durch eine hohe Auflösung, wie sie beispielsweise für die Röntgenlithographie gefordert wird, aus.

Für Beleuchtungsoptiken für die EUV-Lithographie, wie beispielsweise in der DE 199 03 807 oder der WO 99/57732, werden außer an die Auflösung auch hohe Anforderungen an die Gleichmäßigkeit bzw. Uniformität und Telezentrie gestellt. Bei derartigen Systemen wird für bestimmte Lichtquellen das Licht der Lichtquelle durch einen Kollektor gesammelt.

Aufgabe der Erfindung ist es, einen Kollektor für ein Beleuchtungssystem für die Mikrolithographie mit Wellenlängen ≤ 193 nm, vorzugsweise < 126 nm, besonders bevorzugt für Wellenlängen im EUV-Bereich anzugeben, der den hohen Anforderungen an die Uniformität und Telezentrie, die für Beleuchtungsoptiken erforderlich sind, gerecht werden. Insbesondere soll eine möglichst homogene Ausleuchtung erreicht werden.

Erfindungsgemäß wird diese Aufgabe durch einen Kollektor mit einer objektseitigen Apertur, die von einer Lichtquelle abgestrahltes Licht aufnimmt sowie die Merkmale des Anspruchs 1 umfaßt, gelöst.

Die Erfinder haben erkannt, daß durch die erfindungsgemäße Ausgestaltung eines genesteten Kollektor in einem Bereich einer Ebene eine weitgehend gleichmäßige Ausleuchtung erreicht werden kann. Besonders bevorzugt ist es, wenn die Spiegelschalen ein ringförmiges Segment eines Ellipsoids, eines Paraboloids oder eines Hyperboloids sind. Für ein Paraboloid ergibt sich ein vollständig paralleles Strahlenbündel und somit eine im Unendlichen liegende Lichtquelle. Will man beispielsweise mit Hilfe eines in der auszuleuchtenden Ebene angeordneten ersten optischen Elementes mit ersten Rasterelementen gemäß dem US-Patent 6 198 793 B1 sekundäre Lichtquellen erzeugen, so müssen bei Spiegelschalen, die als ringförmiges Segment eines Paraboloids ausgebildet sind, die einzelnen Rasterelemente eine sammelnde Wirkung aufweisen.

Die sammelnde Wirkung kann auch auf den Kollektor übertragen werden. Ein derartiger erfindungsgemäßer Kollektor würde Schalen, die Ausschnitte von Ellipsoiden sind, umfassen, so daß ein konvergentes Strahlbündel ausgebildet wird. Durch die Übertragung der sammelnden Wirkung auf einen Kollektor, der Schalen, die Ausschnitte von Ellipsoiden sind, umfaßt, können die ersten Rasterelemente des ersten optischen Elementes beispielsweise als Planfacetten ausgebildet werden.

Kollektoren mit Schalen, die Ausschnitte von Hyperboloide sind, führen zu einem divergierenden Strahlbündel und sind insbesondere dann von Interesse, wenn der Kollektor möglichst klein dimensioniert werden soll.

Im Gegensatz zu den genesteten Kollektoren gemäß dem Stand der Technik zeichnet sich der erfindungsgemäße Kollektor dadurch aus, daß die Ausdehnungen der Reflektoren der unterschiedlichen Schalen in Richtung der Rotationsachse verschieden sind. So kann eine weitgehend homogene Ausleuchtung in einen ringförmigen Bereich in der auszuleuchtenden Ebene realisiert werden. Sind die Abmessungen und Abstände der Reflektoren wie bei dem im einleitenden Teil zitierten Stand der Technik im wesentlichen gleich, so kann zwar beispielsweise ein kollimierter Strahl bzw. ein fokussierter Strahl erreicht werden, eine homogene Ausleuchtung in einem ringförmigen Bereich hingegen nicht. Darüberhinaus können die winkelabhängigen Reflexionsverluste durch geeignete Auslegung des Kollektors kompensiert werden, so daß eine homogene Ausleuchtung in der Ebene erfolgt.

In einer bevorzugten Ausführungsform des erfindungsgemäßen Kollektors ist die Position einer äußeren Spiegelschale von der auszuleuchtenden Ebene weiter entfernt als die Position einer inneren Spiegelschale. Als Position einer Spiegelschale wird dabei der Mittelwert aus Anfangs- und Endpunkt einer Schale bezogen auf die Rotationsachse des Kollektors verstanden. Unter innerer Spiegelschale versteht man die Spiegelschale, die von den beiden Spiegelschalen, der inneren und äußeren Spiegelschale, den geringeren Abstand zur Rotationsachse aufweist. Da die Homogenisierung auch mit den genesteten Kollektoren lediglich in einer diskreten Näherung erreicht wird, ist es von Vorteil, wenn der Kollektor so viele Schalen als möglich umfaßt. Bevorzugt weist der erfindungsgemäße Kollektor mehr als vier, besonders bevorzugt mehr als sieben und insbesondere bevorzugt mehr als zehn Reflektoren in einer schalenförmigen Anordnung auf.

Bei einer isotrop abstrahlenden Lichtquelle gewährleistet der erfindungsgemäße Kollektor, daß gleiche Winkelsegmente auf gleiche Flächen abgebildet werden. Darüber hinaus können die winkelabhängigen Reflexionsverluste durch geeignete Auslegung des Kollektors kompensiert werden, so daß eine homogene Ausleuchtung in der auszuleuchtenden Ebene vorliegt.

Liegt eine nicht-isotrope Quelle vor, so kann die Abstrahlcharakteristik durch den Kollektor in eine homogene Ausleuchtung umgewandelt werden.

In einer bevorzugten Ausführungsform ist die radiale Ausdehnung von mindestens zwei Ringelementen gleich groß und die Ausdehnung in Richtung der Rotationsachse der dem inneren Ringelement zugeordneten Spiegelschale des Kollektors größer als die Ausdehnung in Richtung der Rotationsachse der dem äußeren Ringelement zugeordneten Spiegelschale des Kollektors. Unter innerem Ringelement versteht man das Ringelement, das von den beiden Ringelementen, dem inneren und dem äußerem Ringelement, den geringeren Abstand zu Rotationsachse aufweist.

Vorteilhafterweise ist der erfindungsgemäße Kollektor derart gestaltet, daß daß der Quotient aus einem ersten Verhältnis der radialen Ausdehnung eines ersten Ringelementes zur Winkelausdehnung des zugeordneten Ringaperturelementes und einem zweiten Verhältnis der radialen Ausdehnung eines zweiten Ringelementes zur Winkelausdehnung des zugeordneten Ringaperturelementes gleich groß ist zu dem Quotienten aus einer ersten Strahlstärke, die in das erste Ringaperturelement fließt, und aus einer zweiten Strahlstärke, die in das zweite Ringaperturelement fließt, d.h. es gilt die Gleichung:

$$\frac{d A_1}{d \Omega_1} \div \frac{d A_2}{d \Omega_2} = I(\alpha_1) \div I(\alpha_2)$$

In einer alternativen Ausführungsform der Erfindung ist vorgesehen, die genesteten Spiegelschalen so auszubilden, daß an einer Spiegelschale Mehrfachreflexionen auftreten.

Durch Mehrfachreflexionen an einer Schale können die Reflexionswinkel klein gehalten werden.

Die Reflektivität verhält sich bei Reflexion unter streifendem Einfall mit kleinen Einfallswinkeln von weniger als 20° relativ zur Oberflächentangente bei Materialien wie Molybdän, Niob, Ruthenium, Rhodium, Palladium oder Gold nahezu linear mit dem Einfallswinkel relativ zur Oberflächentangente, so daß die Reflexionsverluste für eine Reflexion unter beispielsweise 16° oder zwei Reflexionen unter 8° annnähemd dieselben sind. Für die maximal erreichbare Apertur des Kollektors ist es jedoch vorteilhaft, mehr als eine Reflexion zu verwenden.

Besonders bevorzugt sind Systeme mit zwei Reflexionen. Kollektoren mit zwei Reflexionen können beispielsweise als genestete Woltersysteme mit ersten Spiegelschalen, die ringförmige Ausschnitte von Hyperboloiden sind, und zweiten Spiegelschalen, die ringförmige Ausschnitte von Ellipsoiden sind, ausgebildet sein.

Woltersysteme sind aus der Literatur, beispielsweise aus Wolter, Annalen der Physik 10, 94 - 114, 1952, bekannt. Betreffend Woltersysteme mit einer reelen Schnittweite, d.h. einem reellen Zwischenbild der Quelle, die durch die Kombination einer Hyperboloidfläche mit einer Ellipsoidfläche gebildet wird, wird auf J. Optics, Vol. 15, 270 - 280, 1984 verwiesen.

Ein besonderer Vorteil von Woltersystemen ist, daß bei einem Woltersystem mit zwei Reflexionen mit Einfallswinkeln kleiner 20˚ relativ zur Oberflächentangente eine maximale Kollektionsapertur von bis zu $NA_{max} \sim 0.985$ entsprechend einem Aperturwinkel von 80˚ gewählt werden kann, wobei man sich immer noch im hochreflektierenden Bereich der Reflexion unter streifendem Einfall mit einer Reflektivität > 70 % befindet.

In einer ersten Ausführungsform der Erfindung ist vorgesehen, daß das erste ringförmige Segment und das zweite ringförmige Segment einer Schale nicht kontinuierlich aneinander anschließen, sondern zwischen erstem und zweitem ringförmigen Segment ein nicht genutzter Bereich der Spiegelschale, eine sogenannte Lücke liegt.

Neben dem Kollektor stellt die Erfindung auch ein Beleuchtungssystem mit einem derartigen Kollektor zur Verfügung. Das Beleuchtungssystem ist bevorzugt ein doppelt facettiertes Beleuchtungssystem mit einem ersten optischen Element mit ersten Rasterelementen und einem zweiten optischen Element mit zweiten Rasterelementen, wie in der US 6,198,793 B1 gezeigt.

Die ersten und/oder zweiten Rasterelemente können Planfacetten oder Facetten mit sammelnder bzw. zerstreuender Wirkung sein.

In einer Ausführungsform der Erfindung kann vorgesehen sein, daß auf dem ersten optischen Element mit ersten Rasterelementen nur ein ringförgmiger Bereich ausgeleuchtet wird. Die ersten Rasterelemente sind dann bevorzugt innerhalb des ringförmigen Bereiches angeordnet.

Das Beleuchtungssystem umfassend den erfindungsgemäßen Kollektor findet bevorzugt in einer Projektionsbelichtungsanlage für die Mikrolithographie Verwendung, wobei eine derartige Projektionsbelichtungsanlage in der WO 01/09681 A2 gezeigt ist. Projektionsbelichtungsanlagen umfassen ein der Beleuchtungseinrichtung nachgeordnetes Projektionsobjektiv, beispielsweise ein 4-Spiegel-Projektionsobjektiv wie in der US 6,244,717 B1 dargestellt.

Die Erfindung soll nachfolgend anhand der Zeichnungen beispielhaft beschrieben werden.

Es zeigen:

Figur 1 eine Prinzipskizze eines Kollektors

Figur 2 Skizze der Ringaperturelementes um eine Lichtquelle

Figur 3 Skizze der Ringelemente in einer Ebene

Figur 4 genesteter Kollektor aus Ellipsoidsegmenten

Figur 5 genesteter Kollektor aus Ellipsoidsegmenten mit unterschiedlicher Schalenzahl wie in Figur 4

Figur 6 refraktiver genesteter Kollektor

Figur 7 i-tes Ellipsensegment eines genesteten Kollektors

Figur 8 Ellipsenschar eines genesteten Kollektors gemäß Ausführungsbeispiel in Tabelle 1

Figur 9 Abbildungsmaßstab β des Ausführungsbeispieles gemäß Tabelle 1 in Abhängigkeit vom bildseitigen Aperturwinkel

Figur 10 Abbildungsmaßstab β des Ausführungsbeispieles gemäß Tabelle 1 in Abhängigkeit vom Radius r in der Ebene 7 in x-Richtung

Figur 11 Projektionsbelichtungsanlage mit einem genesteten Kollektor gemäß der Erfindung

Figur 12 Ausleuchtungsverteilung (Bestrahlungsstärke) der Ringelemente in der Ebene der ersten Rasterelemente der Projektionsbelichtungsanlage gemäß Figur 11 in Abhängigkeit vom radialen Abstand zur Rotationsachse z des Systems.

Figur 13 Projektionsbelichtungsanlage mit Zwischenbild mit einem genesteten Kollektor

Figur 14 Abbildungsmaßstab β eines 8-schaligen genesteten Woltersystems gemäß Figur 17

Figur 15 auszugsweise Darstellung von drei Schalen aus einem genestetes Woltersystem

Figur 16 auszugsweise Darstellung von zwei Schalen aus einem genestetes Woltersystem

Figur 17 8-schaliges genestetes Woltersystem

Figur 18 Skizze zur Erläuterung der Koordinaten einer Kollektorschale, ausgeführt als Woltersystem mit zwei Reflexionen

Figur 19 Ausleuchtungsverteilung (Bestrahlungsstärke) der Ringelemente in der Ebene der ersten Rasterelemente eines Systems gemäß Figur 20 mit einem Kollektor gemäß Figur 17

Figur 20 EUV-Projektionsbelichtungsanlage mit einem genesteten Kollektor gemäß Figur 17

Figur 21 Koordinatensysteme aller Spiegel der EUV-Projektionsbelichtungsanlage gemäß Figur 20 mit dem genesteten Kollektor gemäß Figur 17

Figur 22 erstes optisches Element eines Beleuchtungssystems gemäß Figur 20 mit ersten Rasterelementen

Figur 23 zweites optisches Element eines Beleuchtungssystems gemäß Figur 20 mit zweiten Rasterelementen

In der vorliegenden Anmeldung werden die in nachfolgender Tabelle aufgeführten lichttechnischen Begriffe, nach Naumann/Schröder, "Bauelemente der Optik", Hauser-Verlag 1992, S. 28-29 verwandt.

Tabelle 1:Lichttechnische Begriffe

| Physikalische Größe | Formel | Einheit |
|---|---|---|
| Strahlungsfluß $\Phi_e$ (Radiant Flux) | $\Phi_e = \dfrac{\partial Q}{\partial t}$ | Watt [W] |
| Bestrahlungsstärke $E_e$ (Irradiance oder Flux density) | $E_e = \dfrac{d\Phi_e}{dA_0}$ | Watt/cm$^2$ |
| Strahlstärke $I_e$ (Radiant Intensity) | $I_e = \dfrac{d\Phi_e}{d\Omega}$ | Watt / Sterradian |
| Strahldichte $L_e$ (Radiance) | $L_e = \dfrac{d\Phi_e}{dA_s \cdot \cos\alpha \cdot d\Omega}$ | Watt / cm$^2$ / Sterradian |

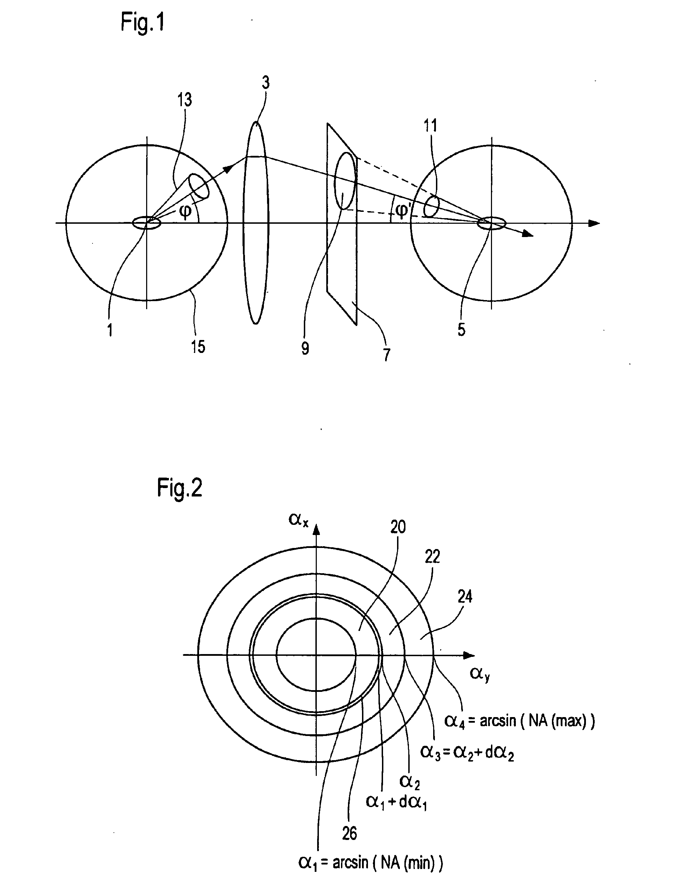

In Figur 1 ist eine Prinzipskizze eines Systems mit Lichtquelle 1, Kollektor 3, Quellbild 5 und Zwischenebene 7 gezeigt. Die Lichtquelle 1 strahlt in den Raum mit einer bestimmten Strahlstärke ab. Diese hängt im allgemeinen vom Winkel $\varphi$ und $\phi$ (Winkel um die z-Achse, nicht eingezeichnet) ab: $I(\varphi \, \phi)$.

Bei axialsymmetrischen Lichtquellen gilt:

$$I(\varphi \, \phi) = I(\varphi).$$

Der nachfolgende Kollektor 3 sammelt das ausgestrahlte Licht und bündelt es. Er bildet die Lichtquelle 1 ab, wobei das Lichtquellenbild 5 entweder reell - wie in Figur 1 dargestellt - oder virtuell sein kann. Auch kann es sich bei der Lichtquelle 1 bereits um ein Bild einer physikalischen Lichtquelle handeln. In einer Ebene 7 hinter dem Kollektor 3 erhält man in beiden Fällen eine bestimmte Ausleuchtung 9, welche der Projektion der Strahlstärke des Strahlungskegels 11, das ist das Raumwinkelelement unter dem Winkel $\varphi'$ im Bildraum des Kollektors, entspricht. Wenn in einer Ebene 7 die Ausleuchtung homogenisiert ist, so ist sie es automatisch auch in jeder anderen Ebene hinter dem Kollektor, sofern sie hinreichend weit entfernt ist von der Bildebene, in der das Bild 5 der Lichtquelle 1 liegt. Dem Strahlungskegel 11 im Bildraum entspricht ein zugehöriger Strahlungskegel 13 im Objektraum, gefüllt mit der abgestrahlten Quell-Strahlstärke $I(\varphi)$ in das Raumwinkelelement unter dem Winkel $\varphi$.

Gemäß der Erfindung wird eine beliebige Lichtquelle 1 in ein Bild der Quelle abgebildet. Das Quellbild kann reell (d.h. in Lichtrichtung rechts vom Kollektor 3) oder virtuell (d. h. in Lichtrichtung links vom Kollektor 3) sein oder im Unendlichen liegen.

Desweiteren wird durch die Erfindung die Abstrahlcharakteristik einer beliebigen Lichtquelle 1 so umtransformieret, daß sich in einer Ebene vor oder hinter dem Zwischenbild eine weitgehend homogene Ausleuchtung ergibt.

Gemäß der Erfindung soll gelten

$$E = \frac{\Phi}{dA} = \frac{R(\alpha) \, I^*(\alpha) \, d\Omega}{dA} = const.$$

E:        Bestrahlungsstärke in der Ebene 7

Φ: Strahlungsfluß

dA: Flächenelement in Ebene 7

dΩ: Winkelelement in der objektseitigen Apertur

I*(α): Strahlstärke der Quelle unter dem Winkel α

R(α): Abschwächungsfaktor proportional zu Lichtverlusten durch die endliche, winkelabhängige Reflektivität des Kollektors (im folgenden wird o.B.d.A. $I(\alpha) = R(\alpha) \cdot I^*(\alpha)$ verwendet)

Für zwei Ringelemente mit gleicher Bestrahlungsstärke muß also gelten:

$$E \approx \frac{\Phi_1}{dA_1} = \frac{I(\alpha_1)\,d\Omega_1}{dA_1} = \frac{\Phi_2}{dA_2} = \frac{I(\alpha_2)\,d\Omega_2}{dA_2}$$

woraus die Beziehung folgt:

$$\frac{d\Omega_2}{dA_2} \div \frac{d\Omega_1}{dA_1} = I(\alpha_1) \div I(\alpha_2)$$

Bei anisotropen Quellen oder starken Unterschieden in den Reflexionsverlusten R(α) müssen die Ringapertursegmente bzw. Ringelemente auf Ebene 7 entsprechend Gl. (2.3) gewählt werden.

Im allgemeinen kann die Aufgabe, ein Zwischenbild zu erzeugen und gleichzeitig eine Abstrahlcharakteristik anzupassen, nicht mit einfachen optischen Elementen wie z. B. einem Spiegel oder einer Linse, erfüllt werden. Bei um die z-Achse, die vorliegend identisch mit der optische Achse des Systems ist, rotationssymmetrischen Abstrahlcharakteristiken kann über eine spezielle Art von Fresnel-Optik zumindest für diskrete Bereiche eine gleiche Ausleuchtung erzielt werden.

Dies wird im folgenden am Beispiel eines reellen Zwischenbildes der Quelle 1 erläutert. Für virtuelle Zwischenbilder oder Quellbild im Unendlichen ergeben sich für den Fachmann in naheliegender Art und Weise ähnliche Konstruktionen.

Man wählt, um die Quelle 1 beispielsweise drei Winkelsegmente bzw. Ringaperturelemente 20, 22, 24 wie in Fig 2 gezeigt, die so angeordent sind, daß in die jeweiligen Winkelsegmente bzw. Ringaperturelemente in radialer Richtung von der Lichtquelle 1 gleichviel Leistung abgestrahlt wird. Bei einer isotrop abstrahlenden Lichtquelle 1, wie beispielsweise einer Dense Plasma Focus Quelle, wählt man dann identische Winkelinkremente dα, bei anisotrop abstrahlenden Quellen paßt man den Winkelabstand entsprechend an, so daß gilt

$$\Phi \approx \int_{\alpha_i}^{\alpha_{i+1}} I(\alpha)\,d\alpha = \Phi_i = const.$$

wobei

Φ$_i$: Strahlungsfluß

I(α): Strahlstärke der Quelle unter dem Winkel α

α$_i$: Breite des i-ten Winkelsegmentes,

α$_{i+1}$: äußerer Winkel des i-ten Segmentes mit $\alpha_{i+1} = \alpha_i + d\alpha_i$  dα$_i$: Breite des i-ten Winkelsegmentes

Über Gleichung (2.4) werden die im allgemeinen unterschiedlichen Winkelinkremente dα$_i$ bestimmt.

In Figur 2 sind die Ringapertursegmente 20, 22, 24 gezeigt. Dargestellt ist ein Beispiel mit drei Segmenten 20, 22, 24 die zwischen NA$_{min}$ und NA$_{max}$ liegen. Die Segmente 22 und 24 schließen aneinander an. Zwischen den Segmenten 20 und 22 besteht eine kleine Lücke 26.

Den einzelnen Ringapertursegmenten bzw. Ringapterurelementen 20, 22, 24 sind in der auszuleuchtenden Ebene 7 Ringelemente 30, 32, 34 zugeordnet. Die Ringelemente 30, 32, 34 werden so gewählt, daß gleich große Abstände dr zwischen den Randstrahlen der Ringelemente erzielt werden. Es gilt also:

$$r_i = r_1 + i \cdot dr$$

wobei

$r_i$:     Abstand des i-ten Ringelementes in der auszuleuchtenden Ebene 7 von der Rotationsachse RA

dr:     Höheninkrement = radiale Ausdehnung

$r_1$:     beliebige Starthöhe (evidente Mittenabschattung bei genesteten Kollektor)

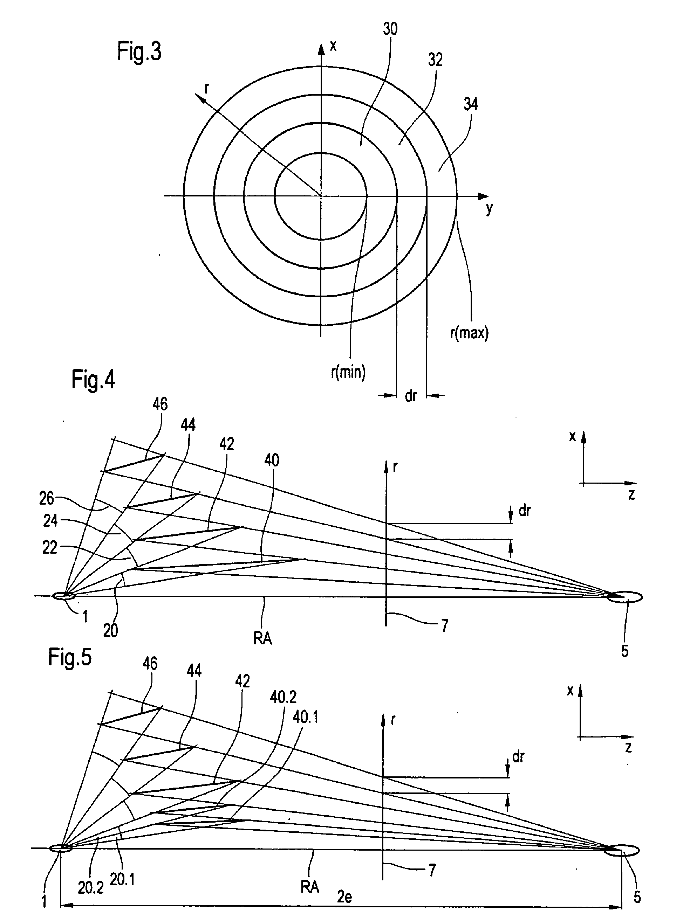

In Figur 3 ist die Ausleuchtung in der Ebene 7 mit Ringelementen 30, 32, 34 gezeigt.

Über die Kreuzungspunkte ausgewählter Strahlen sind dann die jeweiligen Ellipsenschalen des Kollektors 3 festgelegt. Bei einem virtuellem Zwischenbild sind diese hyperbelförmig, bei einem Quellenbild im Unendlichen parabelförmig. Hierzu wird ein repräsentativer Strahl in jeweils einem Ringaperturelement 20, 22, 24 gewählt.

Für eine ellipsoidförmige respektive hyperbel- oder parabelförmige Schale genügen also die Angabe von Objekt- und Bildpunkt, hier Quelle 1 und Quellbild 5, und nur einem weiteren Punkt. Vorliegend sind aber zwei Punkte, nämlich ein Anfangspunkt und ein Endpunkt der Kollektorschale gegeben, d. h. das Problem ist überbestimmt. Da jedoch die Abbildungsqualität für die Quellenabbildung für Beleuchtungszwecke in der Regel weitgehend vernachlässigt werden kann, kann man beispielsweise den Ellipsen respektive Hyperbeln oder Parabeln einen konischen Anteil in Form eines Keils oder Kegelstumpfes hinzufügen, was einer leichten Defokussierung entspricht, die nicht ins Gewicht fällt. Alternativ nimmt man eine geringfügige Abschattung in Kauf, da die auftretenden Lücken sehr gering gewählt werden können. Die Größe der Lücken kann über das Layout und insbesondere die Anzahl der Schalen minimiert werden. Die Lücken wählt man zum Beispiel so, daß sie vorne, d.h. in der aufgenommenen Leistung von der Quelle, auftreten und nicht hinten, in der auszuleuchtenden Fläche.

Es ist auch möglich, den Kollektor nur aus Kegelstümpfen aufzubauen, insbesondere dann, wenn der Kollektor viele Schalen umfaßt. Dies ist unter Fertigungsaspekten vorteilhaft.

Unter Vernachlässigung der Reflexionsverluste und der Abschattungen ist dann gewährleistet, daß sich ein jeweils gleicher Strahlungsfluß $\Phi$ sowohl durch die Winkelsegmente bzw. Ringaperturelemente 20 bis 24 als auch durch die Flächensegmente bzw. Ringelemente 30 bis 34 ergibt.

Prinzipiell ist jedoch auch möglich, die Reflexionsverluste Winkel- und damit segmentabhängig durch geeignetes Vorhalten in den Winkelinkrementen $\alpha_i$ zu kompensieren,wobei, da man die Fläche 7 gemäß der Erfindung weitgehend homogen ausleuchten möchte, die Ringapertursegmente, welche zu Ringsegmenten mit gleichen Inkrementen zugeordnet sind, nicht gleich groß sind.

In Figur 4 ist ein genesteter Kollektor 3 gezeigt, bestehend aus Ellipsoidsegmenten, welche rotationssymmetrisch um die z-Achse angeordnet sind, der eine weitgehend gleichverteilte Ausleuchtung der Ebene 7 gewährleistet. Aufgrund der Rotationssymmetrie um die z-Achse ist nur eine Hälfte des Kollektors 3 im Schnitt dargestellt.

Gemäß Figur 4 ergibt sich eine Schar von Schalen 40, 42, 44, 46, welche etwa äquidistant von der z-Achse, was den maximalen Schalendurchmesser betrifft, welcher etwa proportional zur Schalennummer i ist, angeordnet sind. In Figur 4 ist desweiteren die Lichtquelle 1, die auszuleuchtende Ebene 7 sowie das Quellbild 5 gezeigt. Die Bezugsziffern der anderen Elemente entsprechen denen in den vorangegangenen Figuren.

Alternativ ist eine Anordnung möglich, bei der die Länge der Schalen reduziert wird, wie in Figur 5 gezeigt. Beispielsweise kann das innerste Winkelsegment bzw. Ringaperturelement 20 in zwei Winkelsegmente bzw. Ringaperturelemente 20.1 und 20.2 geteilt werden. Entsprechend wird auch das zugeordnete innerste Ringelement 30 in der Fläche 7 in zwei Ringelemente 30.1, 30.2 geteilt. Es ergeben sich dann zwei Schalen 40.1, 40.2 für die beiden inneren Segmente, welche kürzer als eine Schale 40 sind, wie aus Figur 5 deutlich hervorgeht. Gleiche Bauteile wie in den vorangegangenen Figuren sind mit denselben Bezugsziffern belegt.

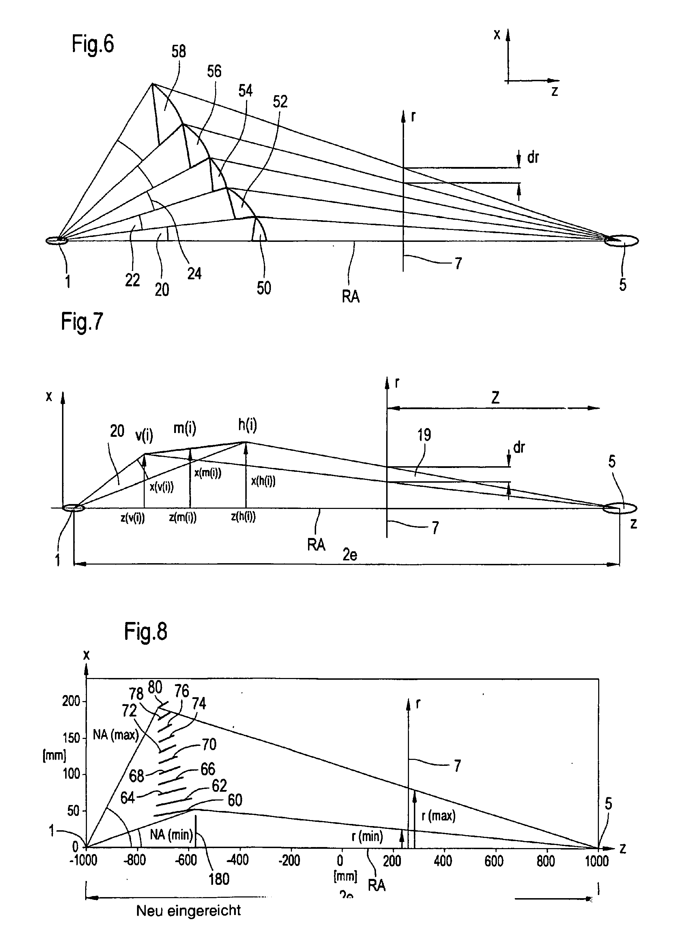

Auch für refraktive Systeme kann man sich ähnliche Anordnung vorstellen. Bei refraktiven Systemen werden die genesteten Spiegelschalen 40, 42, 44, 46 durch ringförmige Off-Axis Segmente von Linsen 50, 52, 54, 56 ersetzt wie in Figur 6 gezeigt.

Figur 6 zeigt schematisch eine Anordnung von ringförmigen off-axis Segmenten von Linsen, welche eine gleichverteilte Ausleuchtung der Ebene 7 für eine bestimmte Abstrahlcharakteristik der Quelle ergibt. Das um die z-Achse rotationssymmetrische System ist im Schnitt nur zur Hälfte schematisch dargestellt. Ungleich große Winkelelemente werden auf gleichgroße Höhensegmente abgelenkt und somit eine homogene Ausleuchtung auch bei anisotroper Quellabstrahlung zu erreichen.

Genestete, reflektive Kollektoren weisen notwendigerweise eine zentrale Abschattung auf, d. h. unterhalb einem bestimmten Aperturwinkel $NA_{min}$ kann die Strahlung der Quelle nicht aufgenommen werden. Diese Strahlung muß daher mit einer Blende abgeblockt werden, damit sie nicht in das nachfolgende Beleuchtungssystem gelangen kann. Die Blende kann z. B. im Bereich des Kollektors angebracht werden.

Nachfolgend soll die Erfindung anhand eines Ausführungsbeispiels näher beschrieben werden.

Ausgegangen wird von einer Punkt-zu-Punkt Abbildung mit reellem Quellenbild bei isotroper Quelle mit einer Ellipsenschar entsprechend der Erfindung, wobei die Schalendurchmesser etwa äquidistant gewählt werden.

Eine Ellipse ist definiert entsprechend der Gleichung

$$\frac{z^2}{a^2} + \frac{x^2}{b^2} = 1$$

wobei

$$e = \sqrt{a^2 - b^2}$$

ist.

In Figur 7 ist beispielhaft das i-te Ellipsensegmenten dargestellt. Da dieses rotationssymmetrisch um z-Achse ist, ist nur eine Hälfte im Schnitt gezeigt.

In Figur 7 sind für eine Spiegelschale die für die Berechnung gemäß Tabelle 1 verwandten Größen dargestellt. Für gleiche Bauteile wie in den vorangegangenen Figuren werden dieselben Bezugsziffern verwandelt. Es bezeichnet

| | |
|---|---|
| $v(i)$ | den i-ten Anfangspunkt der i-ten Spiegelschalen |
| $x(v(i))$ | die x-Koordinate des i-ten Anfangspunktes |
| $z(v(i))$ | die z-Koordinate des i-ten Anfangspunktes, d. h. den Anfangspunkt in Bezug auf die Rotationsachse RA |
| $h(i)$ | den i-ten Endpunkt der i-ten Spiegelschale |
| $x(h(i))$ | die x-Koordinate des i-ten Endpunktes |
| $z(h(i))$ | die z-Koordinate des i-ten Endpunktes, d. h. den Endpunkt in Bezug auf die Rotationsachse RA |
| $m(i)$ | den Mittelwert von Anfangs- und Endpunkt der i-ten Schale |
| $x(m(i))$ | die x-Koordinate des Mittelwertes |
| $z(m(i))$ | die z-Koordinate des Mittelwertes, d. h. den Mittelwert von Anfangs- und Endpunkt der i-ten Schale in Bezug auf die Rotationsachse RA |
| $a, b$ | Parameter der Ellipse |
| $r(i)$ | Abstand des i-ten Ringelementes der i-ten Schale in der auszuleuchtenden Ebene von der Rotationsachse RA |
| $NA(i)$ | Sinus des Öffnungswinkels des inneren Randstrahls des i-ten Ringaperturelementes der i-ten Schale |

Figur 8 zeigt für das mit den oben definierten Parametern berechnete Ausführungsbeispiel die sich ergebende Ellipsenschar der Schalen 60, 62, 64, 66, 68, 70, 72, 74, 76, 80. Die Daten sind in Tabelle 2 angegeben. Alle Längen in Tabelle 2 sind in mm angegeben. Sämtliche Einfallswinkel relative zur Flächentangente sind unter 19˚. Der Einfallswinkel relativ zur Flächentangente des Maximalstrahls beim Ausführungsbeispiel gemäß Figur 8 beträgt 18,54˚.

Als Startwerte wurden gewählt:

Abstand zwischen Ebene 7 und Quellbild 5:

$z = 900$ mm

Halber Brennpunktsabstand:

$e = 1000$ mm

Höheninkrement auf Fläche 7:

$dr = 7,5$ mm

Mittenabschattung in Fläche 7:

$r_{min} \sim 22,5$ mm ($NA'_{min} \sim 0,025$)

minimale Apertur $NA_{min}$ bei Quelle 1:

$NA_{min} = 0,12$

Maximal aufgenomme Apertur $NA_{max}$:

$NA_{max} < 0,55$ entsprechend 33˚

Winkelinkrement an Quelle 1:

d$\alpha_i$ = 2,4˚ = const. (d. h. isotrope Abstrahlcharakteristik der Quelle)

Tabelle 2: Parameter der Ellipsenschar

| i | r(i) | NA(i) | a | b | x(h(i)) | z(h(i)) | x(v(i)) | z(v(i)) | |
|----|--------|-------|----------|---------|---------|----------|---------|----------|---|
| 60 | 22,507 | 0,120 | 1002,009 | 63,422  | 52,266  | -567,601 | 43,117  | -734.837 | |
| 62 | 30,007 | 0,161 | 1003,391 | 82,423  | 66,429  | -593,993 | 57,195  | -722,489 | |
| 64 | 37,507 | 0,203 | 1005,130 | 101,423 | 80,551  | -610,765 | 71,258  | -715,251 | |
| 66 | 45,007 | 0,243 | 1007,231 | 120,475 | 94,679  | -622,848 | 85,334  | -710,997 | |
| 68 | 52,507 | 0,284 | 1009,699 | 139,612 | 108,838 | -632,382 | 99,443  | -708,705 | |
| 70 | 60,007 | 0,324 | 1012,540 | 158,863 | 123,046 | -640,449 | 113,597 | -707,824 | |
| 72 | 67,507 | 0,363 | 1015,762 | 178,250 | 137,317 | -647,655 | 127,810 | -708,034 | |
| 74 | 75,007 | 0,402 | 1019,374 | 197,798 | 151,664 | -654,371 | 142,092 | -709,139 | |
| 76 | 82,507 | 0,440 | 1023,386 | 217,529 | 166,097 | -660,836 | 156,455 | -711,012 | |
| 78 | 90,007 | 0,477 | 1027,808 | 237,466 | 180,628 | -667,215 | 170,909 | -713,571 | |
| 80 | 97,507 | 0,513 | 1032,654 | 257,632 | 195,269 | -673,626 | 185,464 | -716,763 | |
|    |        |       |          |         |         |          |         |          | |

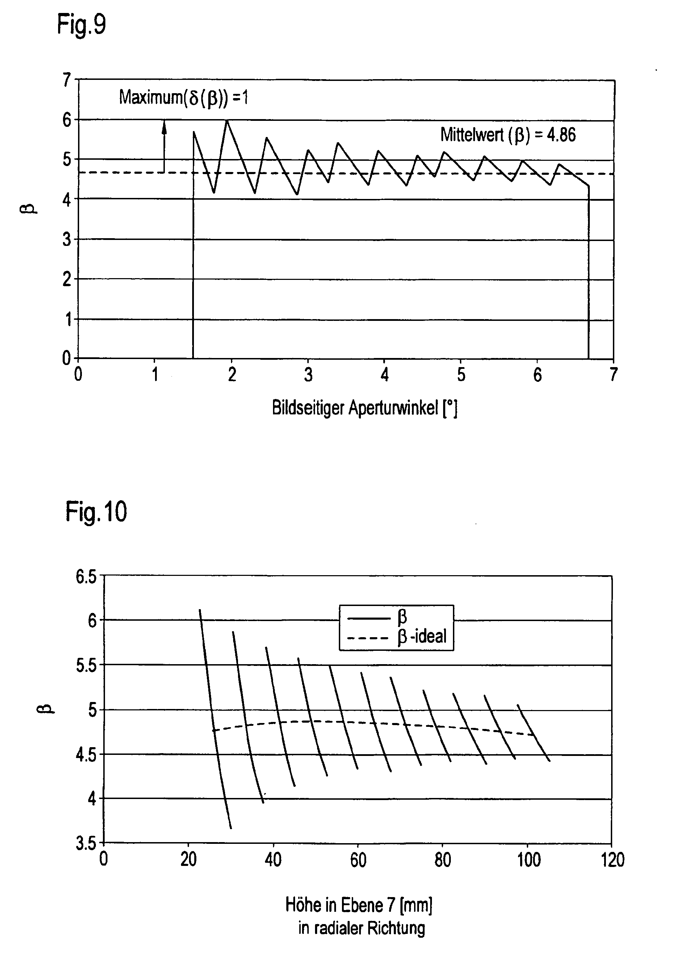

In Figur 9 ist der Abbildungsmaßstab β des Ausführungsbeispieles gemäß Figur 8 und Tabelle 2 als Maß für die Homogenität der Ausleuchtung als Funktion vom bildseitigen Aperturwinkel aufgetragen. Über den Winkel muß der Abbildungsmaßstab β nicht konstant sein, aber über den Maximalradius $r_{max}$ in Ebene 7 muß sich ein bestimmter Abbildungsmaßstab einstellen.

In Figur 10 ist der ideale Abbildungsmaßstab β-ideal und der reale Abbildungsmaßstab β durch diskretisierte Lösung der Kollimationsaufgabe dargestellt in Abhängigkeit von dem Radius r in der Ebene 7. Die Abweichung vom idealen Abbildungsmaßstab kann verringert werden durch eine Vergrößerung der Anzahl der Schalen, beispielsweise durch eine Aufspaltung der inneren Schalen in z.B. jeweils zwei Schalen wie in Figur 5 gezeigt. Damit kann eine noch bessere Homogenisierung der Ausleuchtung in Fläche 7 erreicht werden.

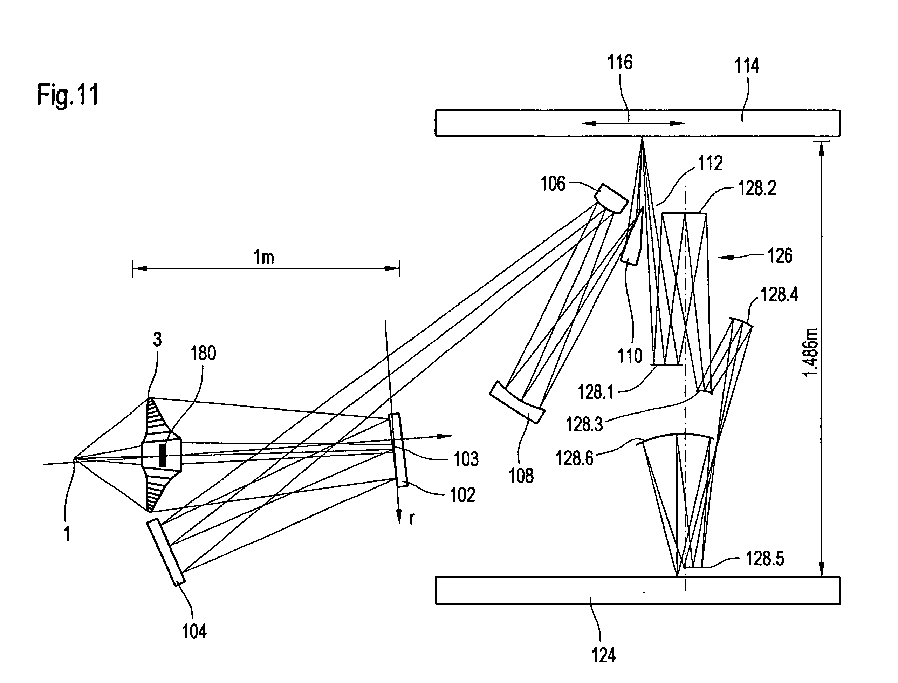

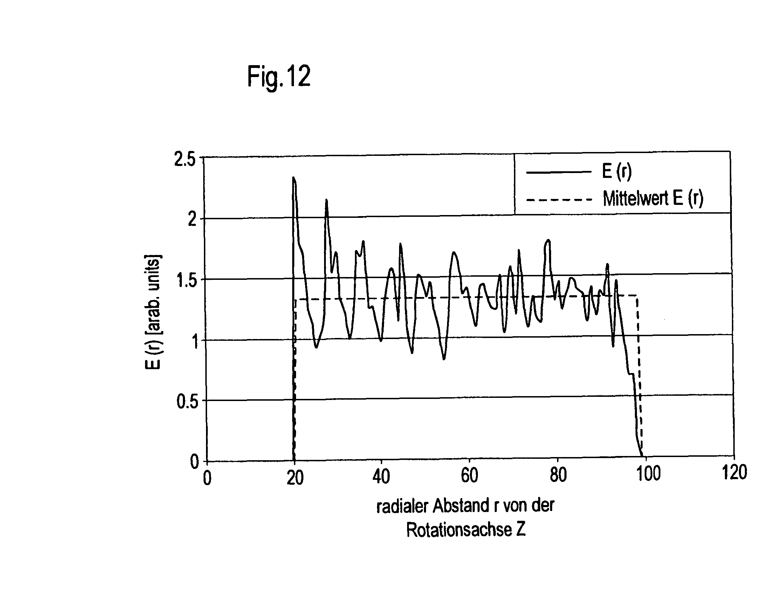

In Figur 11 ist in einer Prinzipansicht eine Projektionsbelichtungsanlage für die Herstellung von beispielsweise mikro-elektronischen Bauteilen, bei der die Erfindung zur Anwendung kommen kann, gezeigt. Die Projektionsbelichtungsanlage umfaßt eine Lichtquelle oder ein Zwischenbild einer Lichtquelle 1. Das von der Lichtquelle 1 ausgesandte Licht, von dem nur vier repräsentative Strahlen gezeichnet sind, wird von einem erfindungsgemäßen genesteten Kollektor 3 gesammelt und auf einen Spiegel 102 mit einer Vielzahl von ersten Rasterelementen, sogenannten Feldwaben gelenkt. Im vorliegenden Fall sind die ersten Rasterelemente plan. Der Spiegel 102 wird auch als Feldwabenspiegel bezeichnet. Die Ausleuchtung in der Feldwabenebene 103 ist in einem vorgegebenen annularen Bereich weitgehend homogen wie in Figur 12 gezeigt. Die Feldebene 103 steht nicht genau senkrecht zur optischen Achse des Kollektors und entspricht damit nicht exakt der homogen auszuleutenden Ebene 7 aus Figur 1. Geringe Neigungswinkel ändern jedoch an der Ableitung nichts und führen nur zu geringen Verzerrungen der Ausleuchtung und damit zu einer vernachlässigbaren Abweichung von der Homogenität, wie sie in einer Ebene senkrecht zur optischen Achse des Kollektors vorliegen würde. Das Beleuchtungssystem ist eine doppelt facettiertes Beleuchtungssystem wie in der US 6,198,793 B1 offenbart. Das System umfaßt somit ein zweites optisches Element mit Rasterelementen 104, die als Pupillenwaben bezeichnet werden. Die optischen Elemente 106, 108 und 110 dienen im wesentlichen dazu, das Feld in der Objektebene 114 zu formen. Das Retikel in der Objektebene ist eine Reflexionsmaske. Das Retikel ist in dem als Scanning-System ausgelegten EUV-Projektionssystem in die eingezeichnete Richtung 116 verfahrbar. Die Austrittspupille des Beleuchtungssystems wird weitgehend homogen ausgeleuchtet. Die Austrittspupille fällt mit der Eintrittspupille eines nachfolgenden Projektionsobjektives zusammen. Die Eintrittspupille des Projektionsobjektives ist nicht dargestellt. Sie befindet sich an der Stelle des Schnittpunktes des vom Retikel reflektierten Hauptstrahles mit der optischen Achse des Projektionsobjektives.

Ein Projektionsobjektiv 126 beispielsweise mit sechs Spiegeln 128.1, 128.2, 128.3, 128.4, 128.5, 128.6 gemäß der US-Patentanmeldung 09/503640 bildet das Retikel auf das zu belichtende Objekt 124 ab.

Figur 12 zeigt die Ausleuchtungsverteilung in der Ebene des ersten optischen Elementes mit ersten Rasterelementen und den Mittelwert der Ausleuchtung. Die Bestrahlungsstärke E (r) ist in Abhängigkeit vom radialen Abstand r von der Rotationsebene z des genesteten Kollektors gezeigt. Deutlich zu erkennen die nur diskrete Erfüllung der homogenisierten Ausleuchtung.

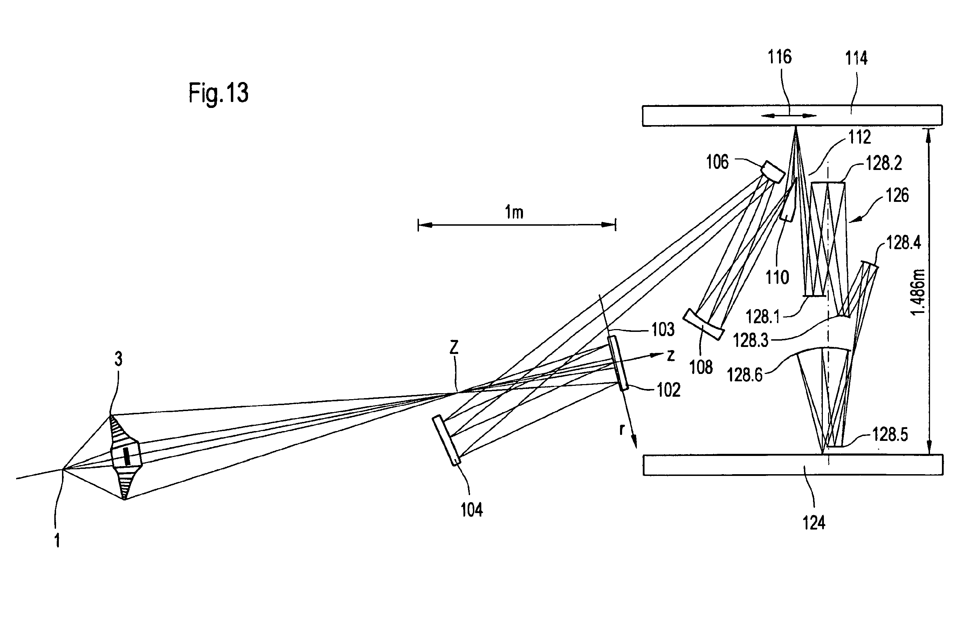

In Figur 13 ist eine Prinzipskizze einer EUV-Projektionsbelichtungsanlage gezeigt, die sich von der in Figur 11 dargestellten Anlage lediglich dadurch unterscheidet, daß die Lichtquelle 1 in ein Zwischenbild Z abgebildet wird. Zusätzlich weisen die ersten Rasterelemente jetzt eine sammelnde Wirkung auf. Das Zwischenbild Z der Lichtquelle 1 wird zwischen Kollektor 3 und dem ersten facettierten Spiegel 102 ausgebildet. Sämtliche anderen Bauelemente sind identisch mit den Bauelementen gemäß Figur 11 und tragen daher dieselben Bezugszeichen.

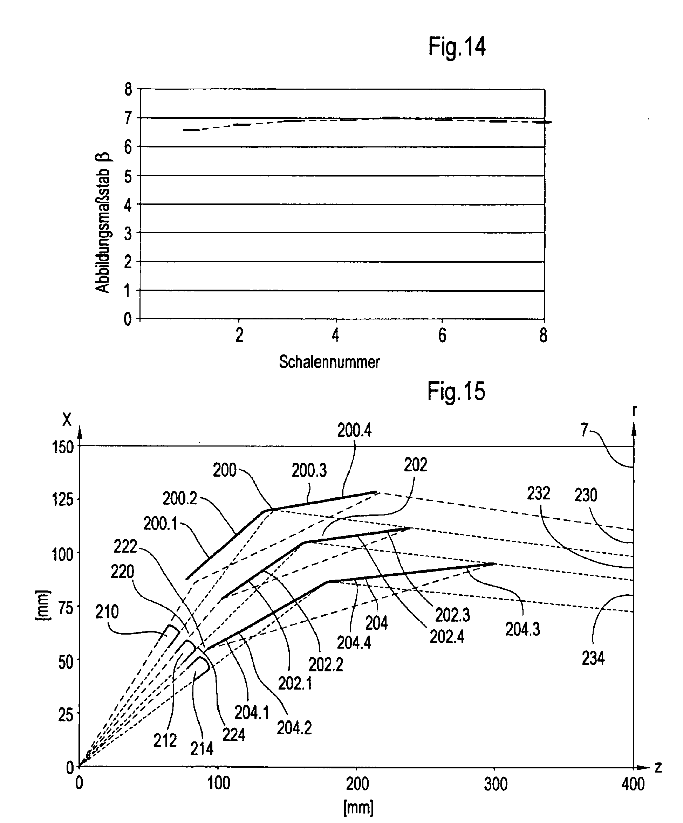

In den nachfolgenden Figuren 14 bis 21 werden erfindungsgemäße genestete Kollektoren beschrieben, die als Woltersysteme ausgeführt sind.

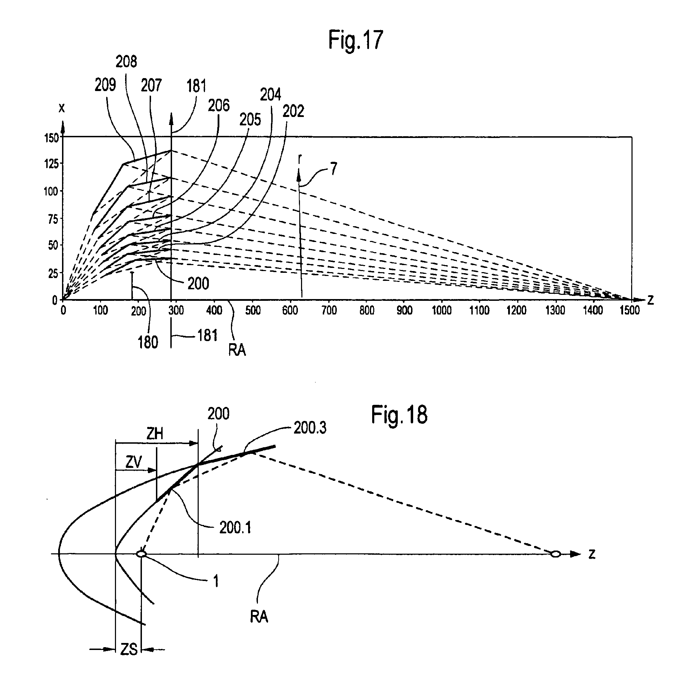

Ein Woltersystem, bestehend vorzugsweise aus einer Kombination eines Hyperboloids und eines Ellipsoids für die reelle Abbildung der Lichtquelle 1 in ein Zwischenbild Z der Quelle, aber auch Hyperboloid-Paraboloid für eine Abbildung nach unendlich, zeichnet sich durch weitgehende Erfüllung der Sinusbedingung aus, d.h. die Vergrößerung bzw. der Abbildungsmaßstab einer Kombination von Hyperboloid und Ellipsoid ist über einen großen Aperturbereich weitgehend konstant. Wie Figur 9 zeigt, variiert bei einem Kollektor zur homogenisierten Ausleuchtung mit nur einfachen Ellisoid-Schalen der Abbildungsmaßstab β innerhalb der Schale sehr stark. Bei einem Woltersystem ist der Abbildungsmaßstab β hingegen innerhalb der Schale weitgehend konstant. Dies ist in Figur 14 für ein 8-schaliges genestetes System gemäß Figur 17 gezeigt, bei dem jede einzelne der genesteten Spiegelschalen ein Woltersystem ist, mit einem ersten ringförmigen Segment mit einer ersten optischen Fläche, die ein Ausschnitt eines Hyperboloides ist und einem zweiten ringförmigen Segment mit einer zweiten optischen Fläche, die ein Ausschnitt eines Ellipsoid ist.

Da, wie in Figur 14 gezeigt, eine Schale eines Woltersystems nahezu einen konstanten Abbildungsmaßstab β aufweist, ist es zur Erreichung einer ideal homogenisierten Ausleuchtung einer Ebene erforderlich, daß in der objektseitigen Apertur Lücken auftreten. Dies gilt insbesondere auch deswegen, weil unter streifendem Einfall an den Schalen, die den größten Abstand zur Rotationsachse aufweisen, die Reflektivität geringer ist als Schalen, die den geringsten Abstand zur Rotationsachse aufweisen. Als Spiegelmaterialien kommen vorzugsweise Molybdän, Niob, Ruthenium, Rodium, Palladium oder Gold in Frage. Das muß durch einen zunehmenden Abbildungsmaßstab kompensiert werden. Zur homogenen Ausleuchtung muß dann von Schale zu Schale der Abbildungsmaßstab geändert werden. Will man dabei eine lückenlose Füllung der Apertur nach dem Kollektor bzw. eine lückenlose Ausleuchtung der Fläche 7 hinter dem genesteten Kollektor erreichen, so treten in der objektseitigen Apertur Lücken auf. Dies ist bei einem Kollektor mit zum Beispiel ellipsoidförmigen Schalen, wie in den Figuren 1 bis 13 beschrieben, nicht der Fall, da dort der Abbildungsmaßstab über die Schale variiert und damit neben der homgenisierten, lückenlosen Ausleuchtung einer Ebene 7 zusätzlich auch eine lückenlose objektseitige Apertur erreicht werden kann.

In Figur 15 sind von einem genesteten Kollektor gemäß der Erfindung examplarisch drei Schalen gezeigt, wobei jede Spiegelschale 200, 202 und 204 ein Woltersystem mit einem ersten ringförmigen Segment 200.1, 202.1, 204.1 mit einer ersten optischen Fläche 200.2, 202.2, 204.2 und einem zweiten ringförmigen Segment 200.3, 202.3, 204.3 mit einer zweiten optischen Fläche 200.4, 202.4, 204.4 aufweist. Die einzelnen Schalen 200, 202, 204 sind rotationssymmetrisch um die z-Achse angeordnet. Der Abbildungsmaßstab β der innersten Schale 200 beträgt 6.7, der der zweiten Schale 202 7.0 und der der äußersten Schale 204 7.5. Wie man aus Figur 15 erkennt, grenzen die Ringaperturelemente 210, 212, 214, die den jeweiligen Spiegelschalen 200, 202 und 204 zugeordnet sind, nicht aneinander, d.h. die objektseitige Apertur des in Figur 15 gezeigten Kollektors weist zwischen den einzelnen Ringaperturelementen 210, 212, 214 Lücken 220, 222, 224 auf. Die der jeweiligen Spiegelschale 200, 202, 204 zugeordneten Ringelemente 230, 232, 234 in der Ebene 7 schließen zur Erzielung einer homogenen Ausleuchtung eines Bereiches der Ebene 7 weitgehend kontinuierlich aneinander an.

Bei der in Figur 15 dargestellten Ausführungsform schließen auch die erste optische Fläche 200.2, 202.2, 204.2 und die zweite optische Fläche 200.4, 202.4 und 204.4 ohne Lücke direkt aneinander an.

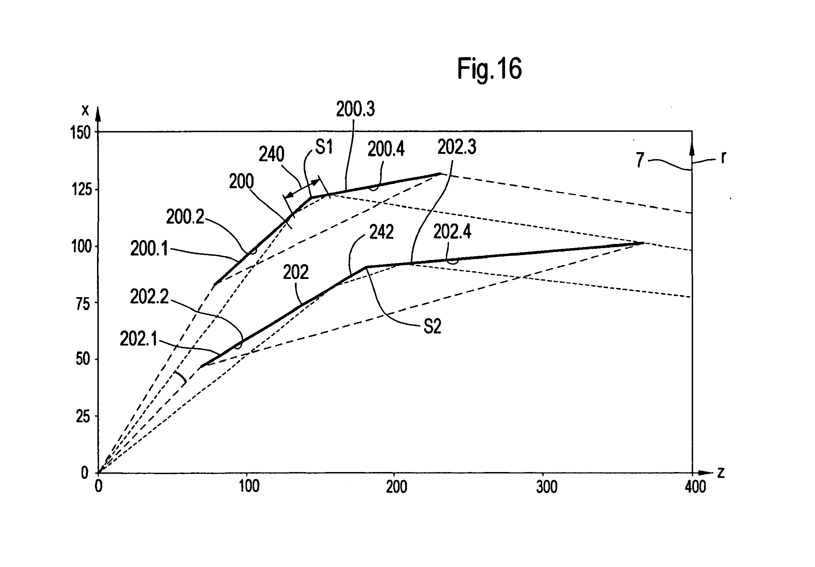

In Figur 16 ist ein weiteres Ausführungsbeispiel der Erfindung, wobei exemplarisch nur zwei Spiegelschalen 200, 202, die als Woltersystem ausgelegt sind, dargestellt sind. Gleiche Bauteile wie in Figur 15 sind mit denselben Bezugsziffern belegt. Bei der Ausführungsform in Figur 16 schließen die erste optische Fläche 200.2, 202.2 und die zweite optische Fläche 200.4, 202.4 nicht direkt aneinander an. Zwischen den optischen Flächen gibt es je eine Lücke bzw. einen ungenutzten Bereich 240, 242. Im ungenutzten Bereich werden im vorliegenden Ausführungsbeispiel die Spiegelschalen jedoch bis zum Schnittpunkt S1, S2 von ersten und zweiten Segment 200.1, 202.1, 200.3, 202.3 der jeweiligen Spiegelschale fortgeführt.

Ein Design mit Lücken bzw. ungenutzten Bereichen, wie in Figur 16 gezeigt, ist vorteilhaft bei ausgedehnten Lichtquellen.

Bei der Auslegung des Kollektors ist stets eine Abwägung zwischen Kollektionseffienz und Homogenität der Ausleuchtung vorzunehmen. Will man in der auszuleuchtenden Fläche 7 lediglich eine Homogenität von ± 15 % erreichen, so kann hierfür ein 8-schaliger Kollektor, wie in Figur 17 gezeigt, eingesetzt werden. Hierbei bezeichnen 200, 202, 204, 205, 206, 207, 208, 209 die jeweiligen Spiegelschalen mit je zwei Spiegelsegmenten, wobei jede Schale ein Woltersystem darstellt.

Der Kollektor aus Figur 17 hat einen Abstand zwischen Quelle 1 und Zwischenbild der Quelle Z von 1500 mm, eine objektseitige Apertur von ~0.72 und eine bildseitige Apertur von ~0.115. Sämtliche Einfallswinkel relativ zur Flächentangente sind ≤ 13˚. Der Einfallswinkel relativ zur Flächtentangente des Maximalstrahls beim Ausführungsbeispiel gemäß Figur 17 beträgt 11,9˚.

In Figur 17 ist des weiteren eine im Inneren der innersten Spiegelschale angeordnete Blende 180 gezeigt. Genestete, reflektive Kollektoren weisen wegen der endlichen Größe der Spiegelschalen notwendigerweise eine zentrale Abschattung auf, d. h. unterhalb eines bestimmten Aperturwinkels $NA_{min}$ kann die Strahlung der Quelle nicht aufgenommen werden. Die Blende 180 verhindert, daß direkt durch die zentrale Schale gelangendes Licht nicht als Falschicht in das nachfolgende Beleuchtungssystem gelangt. Die Blende 180 ist beispielsweise 78 mm hinter der Quelle angeordnet und hat einen Durchmesser von 30.3 mm entsprechend einer Aperturobskuration von $NA_{obs}$ ~ 0.19. die bildseitige Aperturobskuration beträgt entsprechend $NA'_{obs}$ ~ 0.0277.

In Figur 18 sind beispielhaft für die Spiegelschale 200, 202, 204, 205, 206, 207, 208, 209 des Kollektors gemäß Figur 17 die charakteristischen Koordinaten eines Woltersystems, umfassend zwei Segmente, beispielsweise das erste Segment 200.1 und das zweite Segment 200.3 der ersten Spiegelschale 200 dargestellt. Es bezeichnet ZS die z-Position des Flächenscheitels bezogen auf die Position der Lichtquelle 1, ZV und ZH die Anfangs- und Endposition des ersten Segmentes 200.1, das ein Hyperboloid ist, bezogen auf die Position des Flächenscheitels ZS. Für das zweite Segment 200.3 der Spiegelschale, das ein Ellipsoid ist, werden die Bezugzeichen ZS, ZH und ZV in analoger Art und Weise verwandt.

Mit den Krümmungsradien R und der konischen Konstanten K des jeweiligen Spiegelsegmentes sowie den angegebenen Definitionen ergeben sich die Designdaten des Kollektors gemäß Figur 17 aus nachfolgender Tabelle 3. Als Beschichtung der Spiegelschalen wurde Ruthenium gewählt.

Tabelle 3:Designdaten des Kollektors gemäß Figur 17

|  | Hyperboloid |  |  |  |  |
|---|---|---|---|---|---|
| Schale | R [mm] | K | ZS [mm] | ZV [mm] | ZH [mm] |
| 1 | 1.5866 | -1.0201 | -0.79 | 108.99 | 185.86 |
| 2 | 2.3481 | -1.0286 | -1.17 | 107.92 | 183.90 |
| 3 | 3.5076 | -1.0399 | -1.74 | 107.56 | 182.35 |
| 4 | 5.0414 | -1.0571 | -2.49 | 105.05 | 179.53 |
| 5 | 7.2534 | -1.0814 | -3.56 | 102.83 | 177.68 |
| 6 | 10.4354 | -1.1182 | -5.07 | 99.95 | 175.90 |
| 7 | 15.0523 | -1.1755 | -7.22 | 94.87 | 173.09 |
| 8 | 22.3247 | -1.2660 | -10.50 | 88.88 | 169.39 |
|  | Ellipsoid |  |  |  |  |
| Schale | R[mm] | K | ZS[mm] | ZV[mm] | ZH[mm] |
| 1 | 2.3724 | -0.9971 | -160.94 | 349.66 | 433.46 |
| 2 | 3.3366 | -0.9960 | -168.17 | 353.68 | 440.17 |
| 3 | 4.6059 | -0.9945 | -181.56 | 363.50 | 454.10 |
| 4 | 6.4739 | -0.9923 | -184.74 | 364.03 | 457.33 |
| 5 | 9.0813 | -0.9893 | -189.80 | 366.19 | 463.15 |
| 6 | 12.8589 | -0.9849 | -193.20 | 365.14 | 466.03 |
| 7 | 18.4682 | -0.9783 | -195.28 | 362.33 | 470.02 |
| 8 | 26.8093 | -0.9688 | -202.36 | 362.94 | 480.72 |

Das Ausführungsbeispiel des Woltersystems gemäß Figur 17 mit acht Schalen ist so gewählt, daß alle Schalen in etwa in einer Ebene 181 enden. Damit können alle Schalen in einer Ebene 181 gefaßt werden. Vorzugsweise ist die Blende 180 in oder nahe dieser Ebene angeordnet.

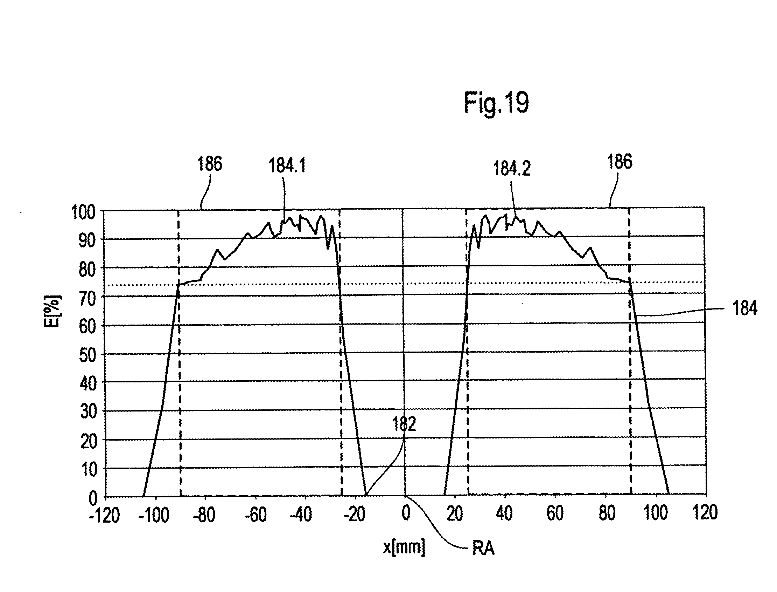

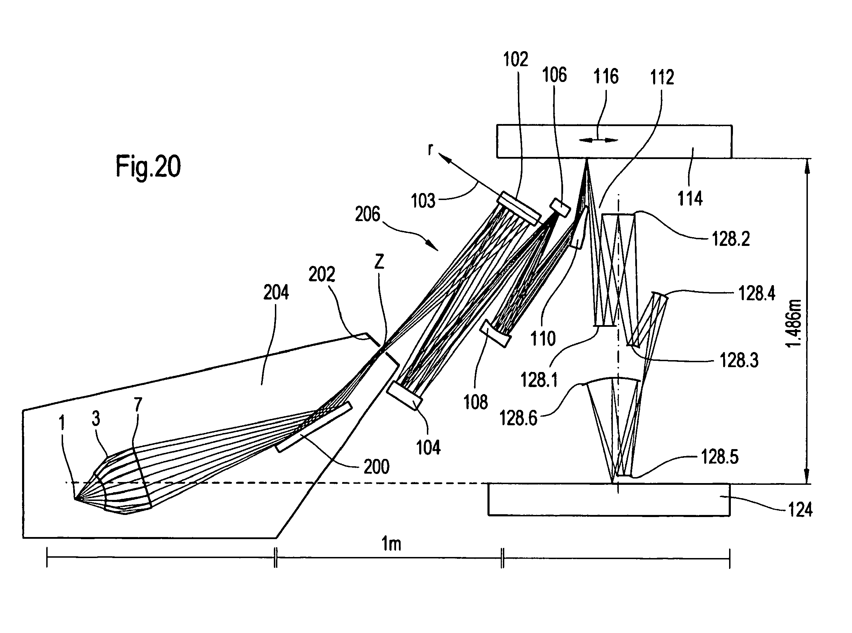

In Figur 19 ist die ermittelte Ausleuchtungsverteilung in der Ebene 7 des Beleuchtungssystems gemäß Figur 20 gezeigt. Das Beleuchtungssystem gemäß Figur 20 umfaßt direkt hinter der Lichtquelle einen 8-schaligen genesteten Kollektor gemäß Figur 17. Der Berechnung der Bestrahlungsstärke gemäß Figur 19 wurde eine Ruthenium-Beschichtung der Spiegelschalen mit deren winkelabhängiger Reflektivität zugrundegelegt. Für andere Beschichtungen kann das Design des Kollektors entsprechend angepaßt werden.

In Figur 19 ist die Mittenabschattung durch die Blende 180 deutlich zu erkennen. Die Mittenabschattung ist mit der Bezugsziffer 182 belegt. Der Verlauf der Intensität in der Ebene 7 ist mit 184 bezeichnet. Deutlich zu erkennen sind zwei zur Rotationsachse RA des Kollektors symmetrische Intensitätspeaks 184.1, 184.2, die in der Ebene 7 zu einer ringförmigen Ausleuchtung führen. Die gestrichelte Kurve 186 gibt den Bereich an, in dem auf dem ersten optischen Element 102 des Beleuchtungssystems gemäß Figur 20 erste Rasterelemente angeordnet sind.

Die optischen Komponenten und der Strahlverlauf einiger Lichtstrahlen einer Projektionsbelichtungsanlage mit einem genesteten Kollektor gemäß Figur 17 sind in Figur 20 gezeigt. Gleiche Bauteile wie bei der Projektionsbelichtungsanlage gemäß Figur 11 sind mit denselben Bezugsziffern belegt.

Im Gegensatz zur Projektionsbelichtungsanlage gemäß Figur 11 ist das Beleuchtungssystem nicht wie ein "X" gefaltet, sondern auf kompakten Bauraum optimiert. Zur Reduktion der Systemlänge ist ferner die bildseitige Apertur des genesteten Kollektors 3, der einen Aufbau wie in Figur 17 hat, auf NA = 0.115 erhöht, wofür die Auslegung als Woltersystem besonders vorteilhaft ist. Die objektseitige Apertur beträgt NA ~ 0.71. Zusätzlich eingefügt ist auf den Kollektor 3 folgend ein Planspiegel 200 zur Faltung des Systems, um Bauräume für mechanische und elektronische Komponenten in der Objektebene 114, in der der Waferstage angeordnet ist, zur Verfügung zu stellen. Das gesamte optische System ist weniger als 3 m lang und weniger als 1.75 m hoch.

Der Planspiegel 200 ist in der vorliegenden Ausführungsform als diffraktives Spektralfilter ausgelegt worden, d.h. durch ein Gitter realisiert. Zusammen mit der Blende 202 in der Nähe des Zwischenbildes Z der Quelle kann damit ungewünschte Strahlung mit beispielsweise Wellenlängen wesentlich größer als der gewünschten Wellenlänge, im vorliegenden Fall 13.5 nm, vom Eintritt in den Teil des hinter der Blende 202 liegenden Beleuchtungssystems abgehalten werden.

Die Blende 202 kann auch dazu dienen, den Raum 204 umfassende Lichtquelle 1, den genesteten Kollektor 3 sowie den als Gitter ausgelegten Planspiegel 200 vom nachfolgenden Beleuchtungssystem 206 räumlich zu trennen. Werden beide Räume durch das Einbringen eines Ventiles nahe des Zwischenfokus Z getrennt, so ist auch eine druckmäßige Trennung möglich. Durch eine räumliche beziehungsweise eine druckmäßige Trennung kann verhindert werden, daß Verschmutzungen, die von der Lichtquelle herrühren in das hinter der Blende 202 liegende Beleuchtungssystem gelangen.

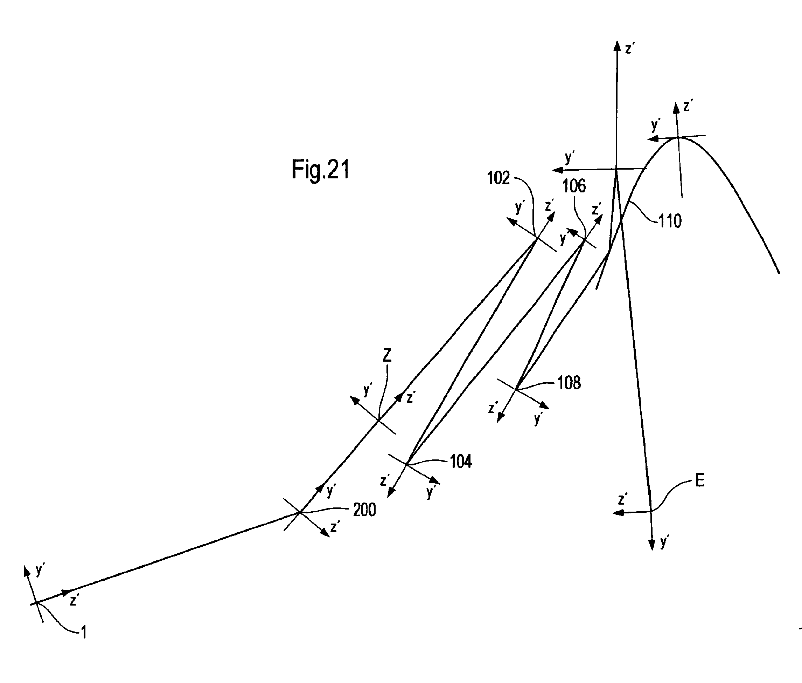

Das in Figur 20 gezeigte Beleuchtungssystem umfaßt einen genesteten Kollektor 3 mit 8 Schalen gemäß Figur 17 sowie Tabelle 3. Der Planspiegel 200 des Designs gemäß Figur 20 ist als Spektralfilter mit einem Beugungswinkel von 2° zwischen 0. und genutzter Beugungsordnung ausgebildet. Das erste optische Element 102 umfaßt 122 erste Rasterelemente mit einer Ausdehnung von jeweils 54 mm x 2.75 mm. Das zweite optische Element 104 weist 122 den ersten Rasterelementen zugeordneten zweiten Rasterelementen mit einem Durchmesser von jeweils 10 mm. Alle Ortsangaben der optischen Komponenten in Tabelle 4 sind auf das Referenz-Koordinatensystem in der Objektebene 114 bezogen. Die Dehnung um den Winkel a um die lokale x-Achse der der jeweiligen optischen Komponente zugeordneten lokalen Koordinaten-Systeme ergeben sich nach translatorischer Verschiebung des Referenz-Koordinationssystemes an den Ort des lokalen Koordinatensystems. Die Parameter der optischen Komponenten des Beleuchtungssystems gemäß Figur 20 sind in Tabelle 4 angegeben. In Tabelle 4 sind die Positionen der Scheitelpunkte der einzelnen optischen Elemente bezüglich der Objektebene 114 angegeben und die Drehwinkel a der Koordinatensysteme um die x-Achse. Des weiteren werden rechtshändige Koordinatensysteme und Drehung im Uhrzeigersinn zugrundegelegt. Neben den lokalen Koordinatensystemen der optischen Komponenten sind die lokalen Koordinatensysteme des Zwischenfokusses Z und der Eintrittspupille E angegeben. Der feldformende Spiegel 110 besteht aus einem außeraxialen Segment eines Rotationshyperboloids. Die Koordinatensysteme für sämtliche in Tabelle 4 beschriebenen optischen Elemente des Beleuchtungssystem gemäß Figur 20 ausgenommen dem genesteten Kollektor 3 sind in Figur 21 gezeigt. Sämtliche optischen Elemente sind mit denselben Bezugsziffern wie in Figur 20 belegt.

Das System ist für einen Feldradius von 130 mm bei einer Beleuchtungsapertur von NA = 0.03125 in der Objektebene 114, d. h. am Retikel ausgelegt, entsprechend einem Füllgrad von $\sigma = 0.5$ in der Eintrittspupille E eines nachfolgenden 4:1-Projektionsobjektives mit einer Apertur NA = 0.25 in der Ebene 124 des zu belichtenden Objektes.

Tabelle 4: Designdaten des Systems gemäß Figur 20

| Position | Y | Z | $\alpha$ | Scheitelkrümmungsradius | konische Konstante |
|---|---|---|---|---|---|
| Licht-Quelle 1 | 2148.137 | -1562.205 | 70.862 | - keine Spiegelfläche - | |
| Planspiegel bzw. Spektralfilter 200 | 1184.513 | -1227.797 | 147.434 | Plan | |
| Zwischenfokus Z | 883.404 | -893.382 | 42.000 | - keine Spiegelfläche - | |

(fortgesetzt)

| Position | Y | Z | α | Scheitelkrümmungsradius | konische Konstante |
|---|---|---|---|---|---|
| erstes facettiertes optisches Element 102 | 302.599 | -248.333 | 36.000 | -898.54 | sphärisch |
| zweites facettiertes optisches Element 104 | 773.599 | -1064.129 | 214.250 | -1090.15 | sphärisch |
| Spiegel 106 | 126.184 | -250.216 | 31.500 | 288.1 | sphärisch |
| Spiegel 108 | 372.926 | -791.643 | 209.600 | -855.8 | sphärisch |
| Spiegelscheitel von Spiegel 110 | -227.147 | 118.541 | -4.965 | -80.5 | -1.1485701 |
| Objektebene 114 | 0.000 | 0.000 | 0.000 | Plan | |
| Eintrittspupille E | -130.000 | -1236.867 | 0.000 | -keine Spiegelfläche | |

Wie der in den Figuren 1 bis 13 gezeigte genestete Kollektor, so können auch die Schalen des Woltersystems einfach durch Abformtechniken hergestellten werden.

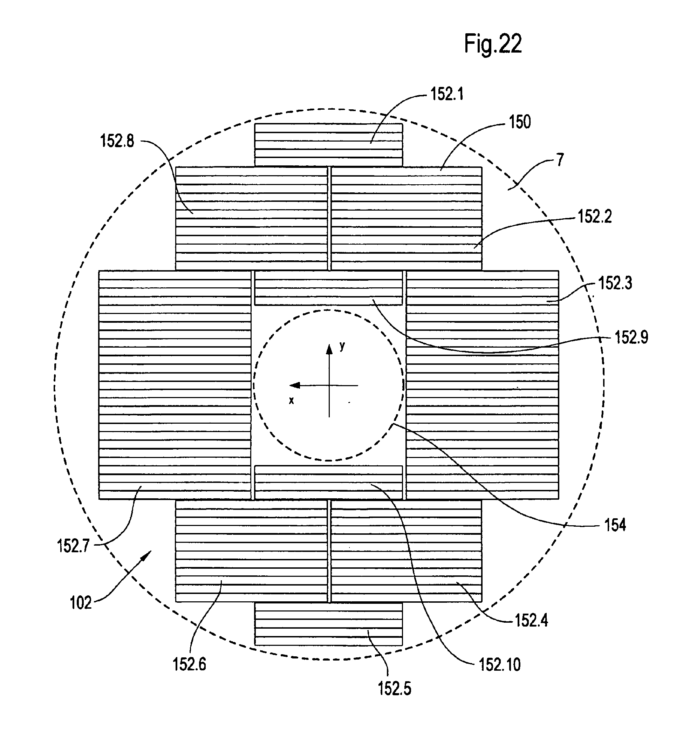

In Figur 22 ist das erste optische Element 102 in der Ebene 7 des Beleuchtungssystems gemäß Figur 20 mit lokalem x-y-Koordinatensystem gezeigt. Deutlich zu erkennen ist die Anordnung der 122 ersten Rasterelemente 150.

Die ersten Rasterelemente 150 sind in zehn zueinander beabstandeten Blöcken 152.1, 152.2, 152.3, 152.4, 152.5, 152.6, 152.7, 152.8, 152.9, 152.10 angeordnet. In dem durch die Zentralabschattung 154 des Kollektors 3 nicht ausgeleuchteten Bereiches in der Ebene 7 sind keine ersten Rasterelemente 150 angeordnet. Die maximale Abweichung der Bestrahlungsstärke zwischen einzelnen ersten Rasterelementen 150 ist bei Einsatz eines genesteten Kollektors gemäß Figur 17 kleiner als ±15%.

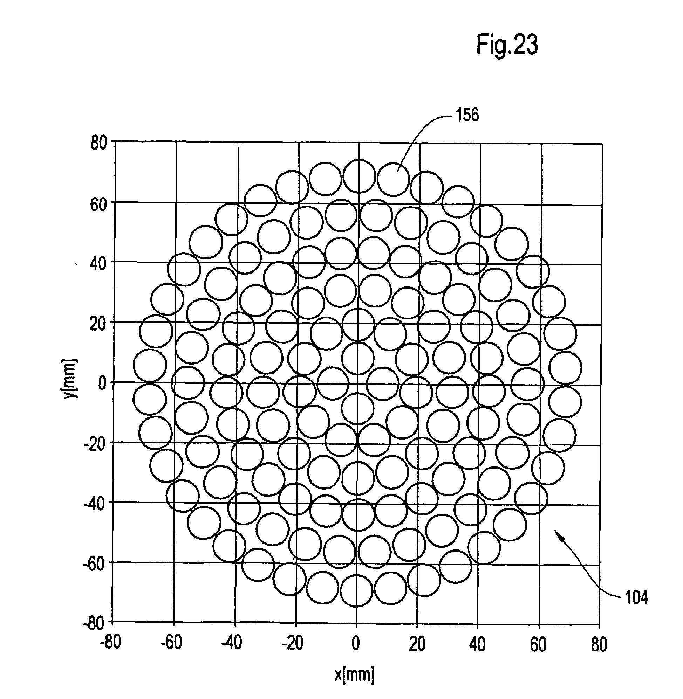

Figur 23 zeigt die Anordnung der zweiten Rasterelemente 156 auf dem zweiten optischen Element 104. Die Bilder der zweiten Rasterelemente 156 füllen die Austrittspupille des Beleuchtungssystemes kontinuierlich bis zu einem gegebenen Füllgrad von σ = 0.5. Betreffend die Definition des Füllgrades in der Austrittspupille wird auf die WO 01/09684 verwiesen.

Mit der Erfindung wird erstmals ein Kollektor angegeben, der eine beliebige Lichtquelle in ein Bild der Quelle abbildet. Das Quellbild kann reell, virtuell oder im Unendlichen liegen. Die Abstrahlcharakteristik der beliebigen Lichtquelle wird so umtransformiert, daß sich in einer Ebene vor oder hinter dem Zwischenbild eine weitgehend homogene Ausleuchtung ergibt.

**Patentansprüche**

1.  Kollektor für Beleuchtungssysteme mit einer Wellenlänge ≤ 193 nm, bevorzugt ≤ 126 nm, besonders bevorzugt EUV-Wellenlängen mit

    1.1 einer objektseitigen Apertur, die von einer Lichtquelle (1) abgestrahltes Licht aufnimmt,

    1.2 einer Vielzahl von rotationssymmetrischen Spiegelschalen (40, 42, 44, 46, 60, 62, 64, 66, 68, 70, 72, 74, 78, 80, 200, 202, 204, 205, 206, 207, 208, 209), welche um eine gemeinsame Rotationsachse ineinander angeordnet sind, wobei jeder Spiegelschale ein Ringaperturelement (20, 22, 24, 210, 212, 214) der objektseitigen Apertur und eine Ausdehnung zugeordnet sind,

    1.3 einem auszuleuchtenden Bereich in einer Ebene (7), der aus Ringelementen (30, 32, 34, 230, 232, 234) besteht, wobei jedem Ringelement (30, 32, 34, 230, 232, 234) ein Ringaperturelement (20, 22, 24, 210, 212, 214) zugeordnet ist,

    wobei

    1.4 die Ringaperturelemente (20, 22, 24, 210, 212, 214) nicht überlappen

    1.5 die Ringelemente (30, 32, 34, 230, 232, 234) nicht überlappen und in der Ebene (7) weitgehend kontinuierlich aneinander anschließen und

    1.6 die Ausdehnungen in Richtung der Rotationsachse, die Flächenparameter und die Positionen der Spiegelschalen (40, 42, 44, 46, 60, 62, 64, 66, 68, 70, 72, 74, 78, 80, 200, 202, 204, 205, 206, 207, 208, 209) derart gestaltet sind, daß die Bestrahlungsstärken der einzelnen Ringelemente (30, 32, 34, 230, 232, 234) in der Ebene (7) weitgehend übereinstimmen

    **dadurch gekennzeichnet, dass**

1.7 die Ausdehnungen der Spiegelschalen (40, 42 ,44 ,46 , 60, 62, 64, 66, 68, 70, 72, 74, 78, 80) in Richtung der Rotationsachse verschieden sind.

**2.** Kollektor gemäß Anspruch 1, **dadurch gekennzeichnet, daß** jeder Spiegelschale ein Anfangs- und ein Endpunkt zugeordnet ist und der Anfangs- und der Endpunkt die Ausdehnung der Spiegelschale in Richtung der Rotationsachse definiert und die Anfangs- und/oder Endpunkte von unterschiedlichen Spiegelschalen in unterschiedlichen Ebenen, die senkrecht auf der Rotationsachse stehen liegen.

**3.** Kollektor nach Anspruch 2, **dadurch gekennzeichnet, daß** der Mittelwert aus Anfangs- und Endpunkt einer Spiegelschale (40, 42 ,44 ,46 , 60, 62, 64, 66, 68, 70, 72, 74, 78, 80, 200, 202, 204, 205, 206, 207, 208, 209) in Bezug auf die Rotationsachse die Position einer Spiegelschale angibt und daß die Position einer äußeren Spiegelschale weiter entfernt ist von der Ebene (7) als die Postion einer inneren Spiegelschale.

**4.** Kollektor nach einem der Ansprüche 1 bis 3, **dadurch gekennzeichnet, daß** der Quotient aus einem ersten Verhältnis der radialen Ausdehnung eines Ringelementes zur Winkelausdehnung des zugeordneten Ringaperturelementes und einem zweiten Verhältnis der radialen Ausdehnung eines zweiten Ringelementes zur Winkelausdehnung des zugeordneten Ringaperturelementes im wesentlichen gleich ist dem Quotienten aus einer ersten Strahlstärke, die um den Reflektivitätsverlust einer ersten Spiegelschale vermindert ist, die in das erste Ringaperturelement fließt, und aus einer zweiten Strahlstärke, die um den Reflektivitätsverlust einer zweiten Spiegelschale vermindert ist, die in das zweite Ringaperturelement fließt.

**5.** Kollektor nach einem der Ansprüche 1 bis 4, **dadurch gekennzeichnet, daß** die Lichtquelle (1) das Licht isotrop abstrahlt und ein erstes Verhältnis der radialen Ausdehnung eines ersten Ringelementes zur Winkelausdehnung des zugeordneten Ringaperturelementes im wesentlichen gleich ist dem zweiten Verhältnis der radialen Ausdehnung eines zweiten Ringelementes zur Winkelausdehnung des zugeordneten Ringaperturelementes.

**6.** Kollektor nach Anspruch 1 bis 5, **dadurch gekennzeichnet, daß** die radiale Ausdehnung von mindestens zwei Ringelementen (30, 32, 34) gleich groß ist und die Ausdehnung in Richtung der Rotationsachse der dem inneren Ringelement (30) zugeordneten Spiegelschale (40, 60) größer ist als die Ausdehnung in Richtung der Rotationsachse der dem äußeren Ringelement (32) zugeordneten Spiegelschale (42, 62).

**7.** Kollektor nach einem der Ansprüche 1 bis 6, **dadurch gekennzeichnet, daß** die Spiegelschalen (40, 42 ,44 ,46 , 60, 62, 64, 66, 68, 70, 72, 74, 78, 80) ringförmige Segmente von Asphären sind.

**8.** Kollektor nach Anspruch 7, **dadurch gekennzeichnet, daß** die Spiegelschalen (40, 42 ,44 ,46 , 60, 62, 64, 66, 68, 70, 72, 74, 78, 80) ein ringförmiges Segment eines Ellipsoids, oder eines Paraboloids oder eines Hyperboloids sind.

**9.** Kollektor nach einem der Ansprüche 1 bis 6, **dadurch gekennzeichnet, daß** mindestens eine Spiegelschale (200, 202, 204, 205, 206, 207, 208, 209) ein erstes Segment (200.1, 202.1, 204.1) mit einer ersten optischen Fläche (200.2, 202.2, 204.4) und ein zweites Segment (200.3, 202.3, 204.3) mit einer zweiten optischen Fläche umfaßt (200.4, 202.4, 204.4).

**10.** Kollektor nach Anspruch 9, **dadurch gekennzeichnet, daß** das erste ringförmige Segment (200.1, 202.1, 204.1) ein Ausschnitt eines Hyperboloides und das zweite ringförmige Segment (200.3, 202.3, 204.3) ein Ausschnitt eines Ellipsoides ist.

**11.** Kollektor nach Anspruch 9, **dadurch gekennzeichnet, daß** das erste ringförmige Segment (200.1, 202.1, 204.1) ein Ausschnitt eines Hyperboloides und das zweite ringförmige Segment (200.3, 202.3, 204.3) ein Ausschnitt eines Paraboloides ist.

**12.** Kollektor nach einem der Ansprüche 1 bis 11, **dadurch gekennzeichnet, daß** mindestens zwei benachbarte Ringaperturelemente nicht kontinuierlich aneinander anschließen.

**13.** Kollektor nach einem der Ansprüche 1 bis 12, **dadurch gekennzeichnet, daß** das innerste Ringaperturelement des Kollektors (3) eine zentrale Aperturobskuration aufweist und die numerische Apertur $NA_{min}$ der Aperturobskuration maximal 0,30, bevorzugt maximal 0,20, besonders bevorzugt maximal 0,15, insbesondere bevorzugt maximal 0,1 beträgt.

**14.** Kollektor nach Anspruch 13, **dadurch gekennzeichnet, daß** innerhalb des innersten Ringaperturelementes des Kollektors (3) eine Blende (180) angeordnet ist.

**15.** Kollektor nach einem der Ansprüche 1 bis 14, **dadurch gekennzeichnet, daß** die objektseitige Apertur eine numerische Apertur $NA_{max}$ von mindestens 0,4, bevorzugt mindestens 0,5, besonders bevorzugt mindestens 0,7 aufweist.

**16.** Kollektor nach einem der Ansprüche 1 bis 15, **dadurch gekennzeichnet, daß** der Kollektor mindestens drei, bevorzugt mehr als sechs, besonders bevorzugt mehr als zehn Spiegelschalen aufweist.

**17.** Kollektor nach einem der Ansprüche 1 bis 16, **dadurch gekennzeichnet, daß** die Strahlen des von der Lichtquelle (1) ausgehenden Strahlbüschels mit Einfallswinkeln kleiner 20˚ zur Flächentangente der Spiegelschalen (40, 42, 44, 46, 60, 62, 64, 66, 68, 7072, 74, 78, 80, 200, 202, 204, 205, 206, 207, 208, 209) auftreffen.

**18.** Beleuchtungssystem für Wellenlängen ≤193 nm, insbesondere < 126 nm), besonders bevorzugt im EUV-Bereich, mit

      18.1 1 einer Lichtquelle (1)
      18.2 wenigstens einem Kollektor (3)
      18.3 einer auszuleuchtenden Ebene (7, 103)
      **dadurch gekennzeichnet, daß**
      18.4 der Kollektor ein Kollektor (3) gemäß einem der Ansprüche 1 bis 17 ist.

**19.** Beleuchtungssystem für Wellenlängen ≤ 193 nm, insbesondere < 126 nm, besonders bevorzugt im EUV-Bereich, gemäß Anspruch 18, **dadurch gekennzeichnet, daß** das Beleuchtungssystem des weiteren ein erstes optisches Element (102), umfassend erste Rasterelemente, (150) aufweist.

**20.** Beleuchtungssystem für Wellenlängen ≤ 193 nm, insbesondere < 126 nm besonders bevorzugt im EUV-Bereich gemäß einem der Ansprüche 18 bis 19, **dadurch gekennzeichnet, daß** der Kollektor (3) in der auszuleuchtenden Ebene (7, 103) einen ringförmigen Bereich ausleuchtet und daß die ersten Rasterelemente (150) des ersten optischen Elementes (102), das in der auszuleuchtenden Ebene (7, 103) angeordnet ist, annährend innerhalb des ringförmigen Bereiches angeordnet sind.

**21.** Beleuchtungssystem für Wellenlängen ≤ 193 nm, insbesondere < 126 nm, besonders bevorzugt im EUV-Bereich, gemäß Anspruch 18 bis 20, **dadurch gekennzeichnet, daß** das Beleuchtungssystem des weiteren optische Elemente (106, 108, 110) zur Abbildung und/oder Feldformung umfaßt.

**22.** Beleuchtungssystem für Wellenlängen ≤ 193 nm, insbesondere < 126 nm, besonders bevorzugt im EUV-Bereich, gemäß einem der Ansprüche 18 bis 21, **dadurch gekennzeichnet, daß** das Beleuchtungssystem zwischen dem Kollektor (3) und der auszuleuchtenden Ebene (103) eine zur Lichtquelle (1) konjugierte Ebene umfaßt, in der ein Zwischenbild (Z) der Lichtquelle (1) ausgebildet wird.

**23.** Beleuchtungssystem für Wellenlängen ≤ 193nm, insbesondere < 126nm, besonders bevorzugt im EUV-Bereich gemäß einem der Ansprüche 18 bis 22, **dadurch gekennzeichnet, daß** im oder nahe dem Zwischenbild (Z) eine Blende (202) angeordnet ist, die einen Raum umfassend mindestens die Lichtquelle (1) und den Kollektor (3) räumlich und/oder druckmäßig vom nachfolgenden Beleuchtungssystem trennt.

**24.** EUV-Projektionsbelichtungsanlage mit

      24.1 einem Beleuchtungssystem gemäß einem der Ansprüche 18 bis 23,
      24.2 einer Maske, die von dem Beleuchtungssystem beleuchtet wird,
      24.3 ein Projektionsobjektiv (126) zur Abbildung der Maske auf
      24.4 ein lichtsensitives Objekt.

**25.** Verfahren zur Herstellung von mikroelektronischen Bauteilen, insbesondere Halbleiter-Bauteilen mit einer EUV-Projektionsbelichtungsanlage gemäß Anspruch 24.

**Claims**

1. A collector for illumination systems with a wavelength $\leq$ 193 nm, preferably $\leq$ 126 nm, more preferably EUV wavelengths, comprising

    1.1. an aperture on the object side which receives light emitted from a light source (1);

    1.2. a plurality of rotational-symmetrical mirror shells (40, 42, 44, 46, 60, 62, 64, 66, 68, 70, 72, 74, 78, 80, 200, 202, 204, 205, 206, 207, 208, 209) which are arranged about a common rotational axis in each other, with each mirror shell being associated with a ring aperture element (20, 22, 24, 210, 212, 214) of the object-side aperture and with an expansion;

    1.3. a section in a plane (7) to be illuminated which consists of ring elements (30, 32, 34, 230, 232, 234), with each ring element (30, 32, 34, 230, 232, 234) being associated with a ring aperture element (20, 22, 24, 210, 212, 214), with

    1.4. the ring aperture elements (20, 22, 24, 210, 212, 214) not overlapping;

    1.5. the ring elements (30, 32, 34, 230, 232, 234) not overlapping and being substantially continuously adjacent in the plane (7), and

    1.6. the expansions in the direction of the rotational axis, the surface parameters and the positions of the mirror shells (40, 42, 44, 46, 60, 62, 64, 66, 68, 70, 72, 74, 78, 80, 200, 202, 204, 205, 206, 207, 208, 209) being arranged in such a way that the irradiance of the individual ring elements (30, 32, 34, 230, 232, 234) substantially correspond in the plane (7), **characterized in that**

    1.7. the expansions of the mirror shells (40, 42, 44, 46, 60, 62, 64, 66, 68, 70, 72, 74, 78, 80) differ in the direction of the rotational axis.

2. A collector according to claim 1, **characterized in that** each mirror shell is associated with a starting and end point and the starting and end point define the expansion of the mirror shell in the direction of the rotational axis and the starting and/or end points of different mirror shells lie in different planes standing perpendicularly to the rotational axis.

3. A collector according to claim 2, **characterized in that** the mean value of starting and end point of a mirror shell (40, 42, 44, 46, 60, 62, 64, 66, 68, 70, 72, 74, 78, 80, 200, 202, 204, 205, 206, 207, 208, 209) with respect to the rotational axis states the position of a mirror shell and that the position of an outer mirror shell is farther away from the plane (7) than the position of an inner mirror shell.

4. A collector according to one of the claims 1 to 3, **characterized in that** the quotient from a first ratio of the radial expansion of a ring element to the angular expansion of the associated ring aperture element and a second ratio of the radial expansion of a second ring element to the angular expansion of the associated ring aperture element is substantially equal to the quotient for a first irradiance which is reduced by the reflectivity loss of a first mirror shell and which flows into the first ring aperture element, and for a second irradiance which is reduced by the reflectivity loss of a second mirror shell and which flows into the second ring aperture element.

5. A collector according to one of the claims 1 to 4, **characterized in that** the light source (1) emits the light in an isotropic way and a first ratio of the radial expansion of a first ring element to the angular expansion of the associated ring aperture element is substantially equal to the second ratio of the radial expansion of a second ring element to the angular expansion of the associated ring aperture element.

6. A collector according to claim 1 to 5, **characterized in that** the radial expansion of at least two ring elements (30, 32, 34) is equally large and the expansion in the direction of the rotational axis of the mirror shell (40, 60) associated with the inner ring element (30) is larger than the expansion in the direction of the rotational axis of the mirror shell (42, 62) associated with the outer ring element (32).

7. A collector according to one of the claims 1 to 6, **characterized in that** the mirror shells (40, 42, 44, 46, 60, 62, 64, 66, 68, 70, 72, 74, 78, 80) are annular segments of aspherics.

8. A collector according to claim 7, **characterized in that** the mirror shells (40, 42, 44, 46, 60, 62, 64, 66, 68, 70, 72, 74, 78, 80) are an annular segment of an ellipsoid or a paraboloid or a hyperboloid.

9. A collector according to one of the claims 1 to 6, **characterized in that** at least one mirror shell (200, 202, 204, 205, 206, 207, 208, 209) comprises a first segment (200.1, 202.1, 204.1) with a first optical surface (200.2, 202.2, 204.4) and a second segment (200.3, 202.3, 204.3) with a second optical surface (200.4, 202.4, 204.4).

**10.** A collector according to claim 9, **characterized in that** the first annular segment (200.1, 202.1, 204.1) is a section of a hyperboloid and the second annular segment (200.3, 202.3, 204.3) is a section of an ellipsoid.

**11.** A collector according to claim 9, **characterized in that** the first annular segment (200.1, 202.1, 204.1) is a section of a hyperboloid and the second annular segment (200.3, 202.3, 204.3) is a section of a paraboloid.

**12.** A collector according to one of the claims 1 to 11, **characterized in that** at least two adjacent ring aperture elements are not continuously adjacent to one another.

**13.** A collector according to one of the claims 1 to 12, **characterized in that** the innermost ring aperture element of the collector (3) comprises a central aperture obscuration and the numeric aperture $NA_{min}$ of the aperture obscuration is at most 0.30, preferably at most 0.20, more preferably at most 0.15, especially preferably at most 0.1.

**14.** A collector according to claim 13, **characterized in that** a diaphragm (180) is arranged within the innermost ring aperture element of the collector (3).

**15.** A collector according to one of the claims 1 to 14, **characterized in that** the aperture on the object side has a numerical aperture $NA_{max}$ of at least 0.4, preferably at least 0.5, especially preferably at least 0.7.

**16.** A collector according to one of the claims 1 to 15, **characterized in that** the collector has at least three, preferably more than six, especially preferably more than ten mirror shells.

**17.** A collector according to one of the claims 1 to 16, **characterized in that** the rays from the ray pencil emitted by the light source (1) impinge with incidence angles of less than 20° to the surface tangent of the mirror shells (40, 42, 44, 46, 60, 62, 64, 66, 68, 70, 72, 74, 78, 80, 200, 202, 204, 205, 206, 207, 208, 209).

**18.** An illumination system for wavelengths $\leq$ 193 nm, especially < 126 nm, more preferably in the EUV range, comprising

    18.1. a light source (1);
    18.2. at least one collector (3);
    18.3. a plane (7, 103) to be illuminated,
    **characterized in that**
    18.4. the collector is a collector (3) according to one of the claims 1 to 17.

**19.** An illumination system for wavelengths $\leq$ 193 nm, especially < 126 nm, more preferably in the EUV range, according to claim 18, **characterized in that** the illumination system further comprises a first optical element (102), comprising first raster elements (150).

**20.** An illumination system for wavelengths $\leq$ 193 nm, especially < 126 nm, more preferably in the EUV range, according to one of the claims 18 to 19, **characterized in that** the collector (3) illuminates an annular section in the plane (7, 103) to be illuminated and that the first raster elements (150) of the first optical element (102) which is arranged in the plane (7, 103) to be illuminated is arranged approximately within the annular section.

**21.** An illumination system for wavelengths $\leq$ 193 nm, especially < 126 nm, more preferably in the EUV range, according to one of the claims 18 to 20, **characterized in that** the illumination system further comprises optical elements (106, 108, 110) for projection and/or field forming.

**22.** An illumination system for wavelengths $\leq$ 193 nm, especially < 126 nm, more preferably in the EUV range, according to one of the claims 18 to 21, **characterized in that** the illumination system comprises a plane conjugated to the light source (1) between the collector (3) and the plane (103) to be illuminated in which an intermediate image (Z) of the light source (1) is formed.

**23.** An illumination system for wavelengths $\leq$ 193 nm, especially < 126 nm, more preferably in the EUV range, according to one of the claims 18 to 22, **characterized in that** a diaphragm (202) is arranged in or close to the intermediate image (Z), which diaphragm separates a space comprising at least the light source (1) and the collector (3) in a spatial and/or pressure-related manner from the subsequent illumination system.

**24.** An EUV projection exposure system, comprising

24.1. an illumination system according to one of the claims 18 to 23;

24.2. a mask which is illuminated by the illumination system;

24.3. a projection objective (126) for projection of the mask onto

24.4. a light-sensitive object.

**25.** A method for producing microelectronic components, especially semiconductor components with an EUV projection exposure system according to claim 24.

**Revendications**

**1.** Collecteur pour des systèmes d'éclairage ayant une longueur d'ondes ≤ 193 nm, de préférence ≤ 126 nm, de préférence dans la plage des EUV, avec

1.1 une ouverture du côté objet recevant la lumière émise par une source lumineuse (1),

1.2 une pluralité de coques de miroir symétriques sur l'axe de rotation (40, 42, 44, 46, 60, 62, 64, 66, 68, 70, 72, 74, 78, 80, 200, 202, 204, 205, 206, 207, 208, 209), qui sont disposées les unes dans les autres autour d'un axe de rotation commun, chaque coque de miroir étant associée à un élément d'ouverture annulaire (20, 22, 24, 210, 212, 214) de l'ouverture côté objet et ayant une étendue,

1.3 une zone à éclairer dans un plan (7) formé d'éléments annulaires (30, 32, 34, 230, 232, 234), chaque élément annulaire (30, 32, 34, 230, 232, 234) étant associé à un élément d'ouverture annulaire (20, 22, 24, 210, 212, 214),

dans lequel

1.4 les éléments d'ouverture annulaires (20, 22, 24, 210, 212, 214) ne se chevauchent pas,

1.5 les éléments d'annulaires (30, 32, 34, 230, 232, 234) ne se chevauchent pas et se raccordent les uns aux autres de manière sensiblement continue dans le plan (7), et

1.6 les étendues dans le sens de l'axe de rotation, les paramètres de surface et les positions des coques de miroir (40, 42, 44, 46, 60, 62, 64, 66, 68, 70, 72, 74, 78, 80, 200, 202, 204, 205, 206, 207, 208, 209) sont tels que les intensités d'exposition des différentes éléments annulaires (30, 32, 34, 230, 232, 234) concordent sensiblement dans le plan (7),

**caractérisé en ce que**

1.7 les étendues des coques de miroir (40, 42, 44, 46, 60, 62, 64, 66, 68, 70, 72, 74, 78, 80) sont différentes dans le sens de l'axe de rotation.

**2.** Collecteur selon la revendication 1, **caractérisé en ce que** chaque coque de miroir est associée à un point de début et un point de fin et le point de début et le point de fin définissent l'étendue de la coque de miroir dans le sens de l'axe de rotation et les points de début et/ou de fin de différentes coques de miroir se trouvent dans différents plans perpendiculaires à l'axe de rotation.

**3.** Collecteur selon la revendication 2, **caractérisé en ce que** la moyenne du point de début et du point de fin d'une coque de miroir (40, 42, 44, 46, 60, 62, 64, 66, 68, 70, 72, 74, 78, 80, 200, 202, 204, 205, 206, 207, 208, 209) par rapport à l'axe de rotation indique la position d'une coque de miroir et **en ce que** la position d'une coque de miroir extérieure est plus éloignée du plan (7) que la position d'une coque de miroir intérieure.

**4.** Collecteur selon l'une des revendications 1 à 3, **caractérisé en ce que** le quotient entre un premier rapport de l'étendue radiale d'un élément annulaire et de l'étendue angulaire de l'élément d'ouverture annulaire associé et un deuxième rapport de l'étendue radiale d'un deuxième élément annulaire et de l'étendue angulaire de l'élément d'ouverture annulaire correspondant est sensiblement égal au quotient d'une première intensité de rayonnement qui est réduite de la perte de réflectivité d'une première coque de miroir, qui passe dans le premier élément d'ouverture annulaire, et d'une deuxième intensité de rayonnement qui est diminuée de la perte de réflectivité d'une deuxième coque de miroir et qui passe dans le deuxième élément d'ouverture annulaire.

**5.** Collecteur selon l'une des revendications 1 à 4, **caractérisé en ce que** la source lumineuse (1) émet la lumière de façon isotrope et un premier rapport entre l'étendue radiale d'un premier élément annulaire et l'étendue angulaire de l'élément d'ouverture annulaire correspondant est sensiblement égal au deuxième rapport entre l'étendue radiale d'un deuxième élément annulaire et l'étendue angulaire de l'élément d'ouverture annulaire correspondant.

**6.** Collecteur selon les revendications 1 à 5, **caractérisé en ce que** l'étendue radiale d'au moins deux éléments annulaires (30, 32, 34) est égale et l'étendue dans le sens de l'axe de rotation de la coque de miroir (40, 60) associée à l'élément annulaire (30) intérieur est plus grande que l'étendue dans le sens de l'axe de rotation de la coque de miroir (42, 62) associée à l'élément annulaire extérieur (32).

7. Collecteur selon l'une des revendications 1 à 6, **caractérisé en ce que** les coques de miroir (40, 42, 44, 46, 60, 62, 64, 66, 68, 70, 72, 74, 78, 80) sont des segments annulaires de formes asphériques.

8. Collecteur selon la revendication 7, **caractérisé en ce que** les coques de miroir (40, 42, 44, 46, 60, 62, 64, 66, 68, 70, 72, 74, 78, 80) sont un segment annulaire d'une ellipsoïde, d'une paraboloïde ou d'une hyperboloïde.

9. Collecteur selon l'une des revendications 1 à 6, **caractérisé en ce qu'**au moins une coque de miroir (200, 202, 204, 205, 206, 207, 208, 209) comporte un premier segment (200.1, 202.1, 204.1) avec une première surface optique (200.2, 202.2, 204.4) et un deuxième segment (200.3, 202.3, 204.3) avec une deuxième surface optique (200.4, 202.4, 204.4).

10. Collecteur selon la revendication 9, **caractérisé en ce que** le premier segment annulaire (200.1, 202.1, 204.1) est un segment d'hyperboloïde et le deuxième segment annulaire (200.3, 202.3, 204.3) un segment d'ellipsoïde.

11. Collecteur selon la revendication 9, **caractérisé en ce que** le premier segment annulaire (200.1, 202.1, 204.1) est un segment d'hyperboloïde et le deuxième segment annulaire (200.3, 202.3, 204.3) un segment de paraboloïde.

12. Collecteur selon l'une des revendications 1 à 11, **caractérisé en ce qu'**au moins deux éléments d'ouverture annulaires voisins ne se raccordement pas en continu l'un à l'autre.

13. Collecteur selon l'une des revendications 1 à 12, **caractérisé en ce que** l'élément d'ouverture annulaire le plus intérieur du collecteur (3) présente une obscuration centrale de l'ouverture et l'ouverture numérique $NA_{min}$ de l'obscuration de l'ouverture est au maximum de 0,30, de préférence au maximum de 0,20, en particulier au maximum de 0,15, et notamment au maximum de 0,1.

14. Collecteur selon la revendication 13, **caractérisé en ce qu'**un volet (180) est disposé dans l'élément d'ouverture annulaire le plus intérieur du collecteur (3).

15. Collecteur selon l'une des revendications 1 à 14, **caractérisé en ce que** l'ouverture côté objet a une ouverture numérique $NA_{max}$ d'au moins 0,4, de préférence d'au moins 0,5, en particulier d'au moins 0,7.

16. Collecteur selon l'une des revendications 1 à 15, **caractérisé en ce qu'**il comporte au moins trois, de préférence plus de six, en particulier plus de dix coques de miroir.

17. Collecteur selon l'une des revendications 1 à 16, **caractérisé en ce que** les rayons du faisceau provenant de la source lumineuse (1) touchent la tangente de surface des coques de miroir (40, 42, 44, 46, 60, 62, 64, 66, 68, 70, 72 74, 78, 80, 200, 202, 204, 205, 206, 207, 208, 209) avec un angle d'incidence inférieur à 20˚.

18. Système d'éclairage pour des longueurs d'ondes ≤ 193 nm, en particulier < 126 nm, de préférence dans la plage des EUV, avec

    18.1 une source lumineuse (1)
    18.2 au moins un collecteur (3)
    18.3 un plan à éclairer (7, 103),
    **caractérisé en ce que**
    18.4 le collecteur est un collecteur (3) selon l'une des revendications 1 à 17.

19. Système d'éclairage pour des longueurs d'ondes ≤ 193 nm, en particulier < 126 nm, de préférence dans la plage des EUV, selon la revendication 18, **caractérisé en ce que** le système d'éclairage comporte en outre un premier élément optique (102), comprenant des premiers éléments de grille (150).

20. Système d'éclairage pour des longueurs d'ondes ≤ 193 nm, en particulier < 126 nm, de préférence dans la plage des EUV selon l'une des revendications 18 à 19, **caractérisé en ce que** le collecteur (3) éclaire une zone annulaire dans le plan à éclairer (7, 103) et **en ce que** les premiers éléments de grille (150) du premier élément optique (102), qui est disposé dans le plan à éclairer (7, 103), sont disposés approximativement à l'intérieur de la zone annulaire.

21. Système d'éclairage pour des longueurs d'ondes ≤ 193 nm, en particulier < 126 nm, de préférence dans la plage des EUV, selon les revendications 18 à 20, **caractérisé en ce que** l'élément d'éclairage comprend en outre des éléments optiques (106, 108, 110) pour la représentation et/ou la mise en forme du champ.

22. Système d'éclairage pour des longueurs d'ondes ≤ 193 nm, en particulier < 126 nm, de préférence dans la plage des EUV, selon les revendications 18 à 21, **caractérisé en ce que** le système d'éclairage comprend entre le collecteur (3) et le plan à éclairer (103) un plan conjugué à la source lumineuse (1), dans lequel est représentée une image intermédiaire (Z) de la source lumineuse (1).

23. Système d'éclairage pour des longueurs d'ondes ≤ 193 nm, en particulier < 126 nm, de préférence dans la plage des EUV, selon l'une des revendications 18 à 22, **caractérisé en ce qu'**il est prévu dans ou près de l'image intermédiaire (Z) un volet (202) qui sépare un espace contenant au moins la source lumineuse (1) et le collecteur (3), dans l'espace et/ou en termes de pression, du système d'éclairage qui leur fait suite.

24. Installation d'éclairage par projection d'EUV avec

   24.1 un système d'éclairage selon l'une des revendications 18 à 23,
   24.2 un masque éclairé par le système d'éclairage,
   24.3 un objectif de projection (126) pour reproduire le masque sur
   24.4 un objet photosensible.

25. Procédé pour la fabrication de composants micro-électroniques, en particulier de composants semi-conducteurs, avec une installation d'éclairage par projection d'EUV selon la revendication 24.

## Fig.1

## Fig.2

$$\alpha_4 = \arcsin ( NA (max) )$$

$$\alpha_3 = \alpha_2 + d\alpha_2$$

$$\alpha_2$$

$$\alpha_1 + d\alpha_1$$

$$\alpha_1 = \arcsin ( NA (min) )$$

Fig.3

Fig.4

Fig.5

**Fig.6**

**Fig.7**

**Fig.8**

Neu eingereicht

Fig.9

Maximum(δ(β)) =1

Mittelwert (β) = 4.86

β

Bildseitiger Aperturwinkel [°]

Fig.10

β

β
β-ideal

Höhe in Ebene 7 [mm]
in radialer Richtung

Fig.11

EP 1 225 481 B1

Fig.12

Fig.13

## Fig.14

## Fig.15

Fig.16

Fig.17

Fig.18

Fig.19

EP 1 225 481 B1

Fig.20

EP 1 225 481 B1

Fig.21

EP 1 225 481 B1

Fig.22

Fig.23

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5768339 A
- US 1865441 A
- US 5763930 A
- US 5745547 A
- DE 3001059 C2
- DE 3001059
- WO 9927542 A
- US 6064072 A
- WO 0063922 A
- WO 0108162 A
- DE 19903807
- WO 9957732 A
- US 6198793 B1
- WO 0109681 A2
- US 6244717 B1
- US 09503640 B
- WO 0109684 A

**In der Beschreibung aufgeführte Nicht-Patentliteratur**

- **WOLTER.** *Annalen der Physik,* 1952, vol. 10, 94-114
- *J. Optics,* 1984, vol. 15, 270-280
- Bauelemente der Optik. Hauser-Verlag, 1992, 28-29